# EUROPEAN PATENT APPLICATION

(11) **EP 4 586 256 A1**
(43) Date of publication of application: **16.07.2025**
(21) Application number: 24766217.4
(22) Date of filing: 25.01.2024
(51) Int. Cl.: G11C 16/26, G11C 16/08, G11C 16/16

(54) **DATA READING METHOD AND APPARATUS, DEVICE, AND READABLE STORAGE MEDIUM**

(30) Priority: 09.03.2023 CN 202310254874
(71) Applicant: Tencent Technology (Shenzhen) Company Limited, Shenzhen, Guangdong 518057 (CN)
(72) Inventor: REN, Zimu, Shenzhen, Guangdong 518057 (CN)
(74) Representative: Reddie & Grose LLP
(86) International application number: PCT/CN2024/073958
(87) International publication number: WO 2024/183494

(57) **Abstract**

A data reading method, executed by a processor of an electronic device. The electronic device comprises a systolic array and a memory cell which are respectively connected to a processor. The systolic array comprises a weight attribute register. The method comprises: acquiring a first weight read request and a first feature mapping read request, the first weight read request being used for requesting to read weight attribute data from the memory cell, and the first feature mapping read request being used for requesting to read feature mapping attribute data from the memory cell (301); acquiring a reference state identifier, the reference state identifier being used for representing the state of the weight attribute register in the systolic array after a preset running time from the current moment, and the weight attribute register being used for registering the weight attribute data (302); if the reference state identifier satisfies a first preset condition, in response to the first weight read request, reading the weight attribute data stored in the memory cell to the systolic array (303); and if the reference state identifier satisfies a second preset condition, in response to the first feature mapping read request, reading the feature mapping attribute data stored in the memory cell to the systolic array, the systolic array being used for performing calculation on the basis of the weight attribute data and the feature mapping attribute data.

## Description

### RELATED APPLICATION

The present application claims priority to Chinese patent application No. 2023102548749, entitled "DATA READING METHOD AND APPARATUS, DEVICE, AND READABLE STORAGE MEDIUM" and filed on March 9, 2023.

### FIELD OF THE TECHNOLOGY

Embodiments of the present disclosure relate to the technical field of computers, and in particular, to a data reading method, a data reading apparatus, a device, and a readable storage medium.

### BACKGROUND OF THE DISCLOSURE

Peak computing power is an index for measuring computer performance in the technical field of computers. It refers to the maximum number of calculations that a processor can achieve within a unit of time, and the ability to read data from a storage unit is closely related to the peak computing power.

In the related art, there is an array structure including a plurality of rows and a plurality of columns of process engines (PEs), and the array structure is referred to as a systolic array. Data in the storage unit may be read and stored into the systolic array and then subject to efficient calculation through the systolic array. Usually, when a condition of reading the data from the storage unit and then storing the read data into the systolic array is not satisfied, the to-be-read data in the storage unit may be first registered by a queue in response to a read request for reading the target data. When the condition of reading the data from the storage unit and then storing the read data into the systolic array is satisfied, the to-be-read data is taken out from the queue and transmitted to the systolic array.

Generally, a chip may carry an object having a data storage function, e.g., carry a storage unit or a queue. The queue needs to utilize some registering resources, which is apt to increase an area of the chip.

### SUMMARY

According to various embodiments of the present disclosure, a data reading method, a data reading apparatus, a device, and a readable storage medium are provided.

According to one aspect, a data reading method is provided and executable by a processor of an electronic device. The electronic device comprises a systolic array and a storage unit that are connected to the processor, and the systolic array comprises a plurality of weight registers configured to register weight data. The method comprises: acquiring a first weight read request and a first feature-map read request, where the first weight read request is configured to request reading the weight data from the storage unit, and the first feature-map read request is configured to request reading feature-map data from the storage unit; acquiring a reference status identifier, where the reference status identifier indicates a predicted status of the weight registers in the systolic array at a first moment, the first moment is post to a current moment by a pre-defined elapsed time interval; reading the weight data from the storage unit and storing the read weight data into the systolic array, in response to the first weight read request and the reference status identifier satisfying a first pre-defined condition; and reading the feature-map data from the storage unit and inputting the read feature map into the systolic array, in response to the first feature-map read request and the reference status identifier satisfying a second pre-defined condition, where the systolic array is configured to perform calculation using the weight data and the feature-map data that are stored in the systolic array.

According to another aspect, a storage system is provided. The system comprises a processing unit and a storage unit. The storage unit is configured to store the weight data and feature-map data. The processing unit is configured to acquire a first weight read request and a first feature-map read request, where the first weight read request is configured to request reading the weight data from the storage unit, and the first feature-map read request is configured to request reading feature-map data from the storage unit. The processing unit is further configured to acquire a reference status identifier, where the reference status identifier indicates a predicted status of the weight registers in the systolic array at a first moment, the first moment is post to a current moment by a pre-defined elapsed time interval. The processing unit is further configured to read the weight data from the storage unit and store the read weight data into the systolic array, in response to the first weight read request and the reference status identifier satisfying a first pre-defined condition. The processing unit is further configured to reading the feature-map data from the storage unit and input the read feature map into the systolic array, in response to the first feature-map read request and the reference status identifier satisfying a second pre-defined condition. The systolic array is configured to perform calculation using the weight data and the feature-map data that are stored in the systolic array.

According to another aspect, a data reading apparatus is provided. The apparatus comprises an acquisition module and a reading module. the acquisition module is configured to acquire a first weight read request and a first feature-map read request, where the first weight read request is configured to request reading weight data from a storage unit, and the first feature-map read request is configured to request reading feature-map data from the storage unit. The acquisition module is further configured to acquire a reference status identifier, where the reference status identifier indicates a predicted status of the weight registers in the systolic array at a first moment, the first moment is post to a current moment by a pre-defined elapsed time interval, and the weight registers are configured to register the weight data. The reading module is configured to read the weight data from the storage unit and store the read weight data into the systolic array, in response to the first weight read request and the reference status identifier satisfying a first pre-defined condition. The reading module is further configured to read the feature-map data from the storage unit and input the read feature map into the systolic array, in response to the first feature-map read request and the reference status identifier satisfying a second pre-defined condition, where the systolic array is configured to perform calculation using the weight data and the feature-map data that are stored in the systolic array.

According to another aspect, an electronic device is provided, comprising a processor and a memory; the memory has at least one computer-readable instruction stored therein, and the at least one computer-readable instruction is loaded and executed by the processor to cause the electronic device to implement the data reading method according to any one of the foregoing aspects.

According to another aspect, a computer-readable storage medium is further provided, having at least one computer-readable instruction stored therein; the at least one computer-readable instruction is loaded and executed by a processor to cause an electronic device to implement the data reading method according to any one of the foregoing aspects.

According to another aspect, a computer program product is further provided, having at least one computer-readable instruction stored therein; the at least one computer-readable instruction is loaded and executed by a processor to cause an electronic device to implement the data reading method according to any one of the foregoing aspects.

Details of one or more embodiments of the present disclosure are provided in the accompanying drawings and descriptions below. Other features, objectives, and advantages of the present disclosure become apparent from the specification, the drawings, and the claims.

### BRIEF DESCRIPTION OF THE DRAWINGS

In order to more clearly illustrate the technical solutions in the embodiments of the present disclosure or in the related art, the drawings required in the descriptions of the embodiments or the related art will be briefly introduced below. It is clear that the drawings described below are only embodiments of the present disclosure, and a person skilled in the art may obtain other drawings according to the disclosed drawings without involving any inventive effort.
FIG. 1 is a schematic diagram of an implementation environment of a data reading method according to an embodiment of the present disclosure.
FIG. 2 is a schematic diagram of loading data into a systolic array according to an embodiment of the present disclosure.
FIG. 3 is a flowchart of a data reading method according to an embodiment of the present disclosure.
FIG. 4 is a schematic diagram of updating a status identifier according to an embodiment of the present disclosure.
FIG. 5 is a schematic diagram of determining whether a sub-request is valid according to an embodiment of the present disclosure.
FIG. 6 is a schematic diagram of a data acquisition process according to an embodiment of the present disclosure.
FIG. 7 is an architectural diagram of a storage system according to an embodiment of the present disclosure.
FIG. 8 is a schematic structural diagram of an arbiter unit according to an embodiment of the present disclosure.
FIG. 9 is a schematic structural diagram of a data reading apparatus according to an embodiment of the present disclosure.
FIG. 10 is a schematic structural diagram of a terminal device according to an embodiment of the present disclosure.
FIG. 11 is a schematic structural diagram of a server according to an embodiment of the present disclosure.
FIG. 12 is an architectural diagram of a storage system according to another embodiment of the present disclosure.

### DESCRIPTION OF EMBODIMENTS

The technical solutions in embodiments of the present disclosure are clearly and completely described in the following with reference to the accompanying drawings in the embodiments of the present disclosure. Apparently, the described embodiments are merely some rather than all of the embodiments of the present disclosure. All other embodiments obtained by a person skilled in the art based on the embodiments of the present disclosure without inventive efforts shall fall within the protection scope of the present disclosure.

To make the objectives, technical solutions, and advantages of the present disclosure clearer, the following further describes implementations of the present disclosure in detail with reference to the accompanying drawings.

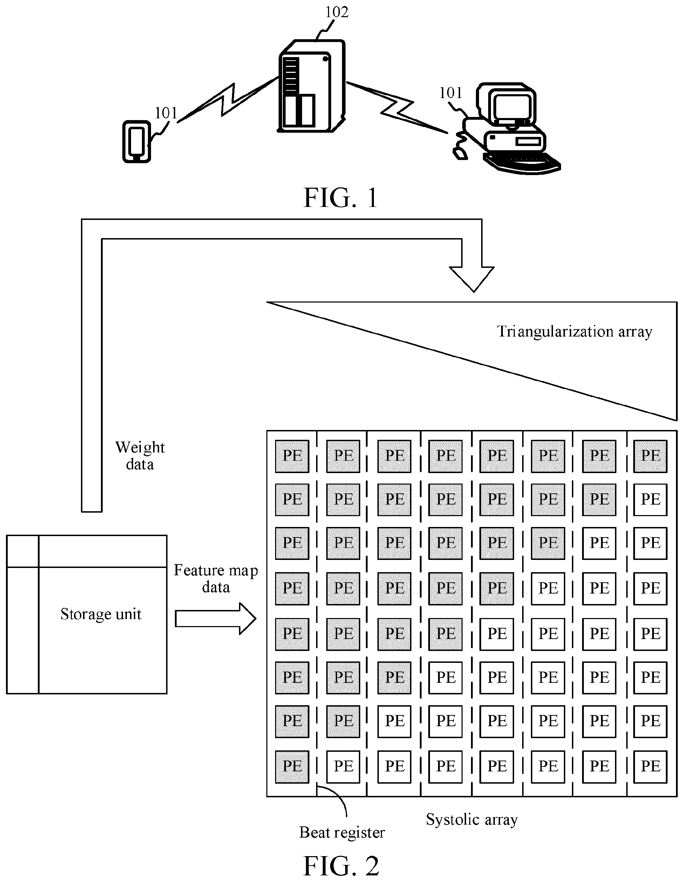

FIG. 1 is a schematic diagram of an implementation environment of a data reading method according to an embodiment of the present disclosure. As shown in FIG. 1, the implementation environment includes a terminal device 101 and a server 102. The data reading method in the embodiments of the present disclosure may be performed by the terminal device 101, or may be performed by the server 102, or may be performed jointly by the terminal device 101 and the server 102.

The terminal device 101 may be a smartphone, a game console, a desktop computer, a tablet computer, a laptop portable computer, a smart television, a smart in-vehicle device, a smart voice interaction device, a smart home appliance, or the like. The server 102 may be one server, a server cluster formed by a plurality of servers, or any one of a cloud computing center or a virtualization center. This is not limited in the embodiments of the present disclosure. The server 102 may be communicatively connected to the terminal device 101 through a wired network or a wireless network. The server 102 may have functions of data processing, data storage, data transmission and reception, and the like. This is not limited in the embodiments of the present disclosure. The numbers of terminal devices 101 and servers 102 are not limited, and there may be one or more terminal devices 101 and one or more servers 102.

For ease of understanding the following embodiments, a systolic array is described below with reference to FIG. 2. Referring to FIG. 2, FIG. 2 is a schematic diagram of loading data into a systolic array according to an embodiment of the present disclosure.

The systolic array is an array structure, and a working manner and process of the systolic array may be similar to a working manner and process of a human blood circulation system. In the systolic array, data flows rhythmically between processing elements (Pes) of the systolic array in a set pipelining manner. During a data flow process, all PEs process data flowing through the PEs in parallel. Therefore, the systolic array may achieve a very high parallel processing speed.

The systolic array includes M rows and N columns of PEs, and M and N are both positive integers greater than 1. In embodiments of the present disclosure including the embodiments of both the claims and the specification (hereinafter referred to as "all embodiments of the present disclosure"), a beat register may be inserted between any two columns of PEs of the systolic array, and/or a beat register may be inserted between any two rows of PEs of the systolic array. Due to a large size of the systolic array, the layout and routing may be facilitated by inserting the beat register, thereby facilitating physical implementation. In addition, since the PEs require a particular amount of time to process data, and a time required for data to flow through a column of PEs is less than a time required for data to flow through an entire systolic array, inserting the beat register can increase a clock frequence, shorten a clock cycle, and decrease a delay. In an exemplary embodiment, the beat register is a one-level beat register. For example, the systolic array as shown in FIG. 2 comprises eight rows and eight columns of PEs, and a beat register is inserted between each adjacent two columns of PEs in the systolic array.

An electronic device may comprise a processor, a storage unit, and a systolic array. The electronic device comprises a systolic array and a storage unit that are connected to the processor, and the systolic array comprise weight registers. The electronic device may read data from the storage unit and load the data into the systolic array. The storage unit is not limited in the embodiments of the present disclosure. As an example, the storage unit is any one of an L1 memory, an L2 memory, an inner disc, and the like.

The embodiments of the present disclosure are applicable to the technical field of artificial intelligence (AI). In the technical field of AI, processing such as feature extraction and classification may be performed on features of media such as image, text, and audio through a neural network model. The essence of processing the features of the media by the neural network model is as follows: model parameters of the neural network model are calculated using the features of the media. Herein the features of the media may be embodied as feature-map data, and the model parameter of the neural network model may be embodied as weight data.

Data in the storage unit includes weight data and feature-map data. When the weight data and the feature-map data are loaded into the systolic array, loading of the weight data and loading of the feature-map data follow a time sequence.

Taking FIG. 2 as an example, the electronic device may read the weight data from the storage unit. The read weight data needs to be converted into "beats" through a triangularization array, where horizontal data (or row-wise data) is converted into skewed triangular data (or triangular matrix data) and then inputted into the systolic array. Since the beat registers are inserted into the systolic array, the weight data needs to be converted to follow the beats through the triangularization array.

As an example, the systolic array includes 8 rows and 8 columns of PEs. In the 1^{st} clock cycle, the electronic device may load the weight data from the storage unit in response to a read request for reading the weight data. The weight data is inputted into the systolic array after passing through the triangularization array. In this case, the weight data is located in the PE at the 1^{st} row and the 1^{st} column of the systolic array. In a second clock cycle, the electronic device may load the weight data from the storage unit in response to another read request for reading the weight data. The weight data is inputted into the systolic array after passing through the triangularization array. In this case, the weight data is located in the PEs at the 1^{st} row and the 1^{st} column, at the 2^{nd} row and the 1^{st} column, and at the 1^{st} row and the 2^{nd} column of the systolic array. The weight data loaded in the first clock cycle is located in the PE at the 2^{nd} row and the 1^{st} column, and the weight data loaded in the second clock cycle is located in the PEs at the 1^{st} row and the 1^{st} column and the 1^{st} row and the 2^{nd} column. In a third clock cycle, the electronic device may load the weight data from the storage unit in response to yet another read request for reading the weight data. The weight data is inputted into the systolic array after passing through the triangularization array. In this case, the weight data is located in PEs in the 1^{st} to 3^{rd} rows of the 1^{st} column, the 1^{st} and 2^{nd} rows of the 2^{nd} column, and the 1^{st} row of the 3^{rd} column of the systolic array. The weight data loaded in the first clock cycle is located in the PE at the 3^{rd} row and the 1^{st} column, the weight data loaded in the second clock cycle is located at the PEs at the 2^{nd} row and the 1^{st} column and at the 2^{nd} row and the 2^{nd} column, and the weight data loaded in the third clock cycle is located in the PEs at the 1^{st} row and the 1^{st} column, at the 1^{st} row and the 2^{nd} column, and at the 1^{st} row and the 3^{rd} column. The rest clock cycles may be deduced by analogy.

It can be known from the foregoing descriptions of the 1^{st} to the 3^{rd} clock cycle that, flowing of the weight data loaded in the first clock cycle is flowing from the PE in the 1^{st} row of the 1^{st} column to the PE in the 2^{nd} row of the 1^{st} column, and then flowing to the PE in the 3^{rd} row of the 1^{st} column. Flowing of the weight data loaded in the second clock cycle is flowing from the PEs in the 1^{st} row of the 1^{st} column and the 1^{st} row of the 2^{nd} column to the PEs in the 2^{nd} row of the 1^{st} column and the 2^{nd} row of the 2^{nd} column. That is, after each clock cycle, the weight data already loaded into the systolic array "sinks" by one row. In addition, the weight data is loaded to the PE in the first row of the 1^{st} column in the first clock cycle, the weight data is loaded to the PEs in the 1^{st} row of the 1^{st} column and the 1^{st} row of the 2^{nd} column in the second clock cycle, and the weight data is loaded into the PEs in the 1^{st} row of the 1^{st} column, the 1^{st} row of the 2^{nd} column, and the 1^{st} row of the 3^{rd} in the third clock cycle. That is, in each clock cycle, a new row of weight data is loaded into the systolic array, and such row of weight data occupies one more column than the weight data loaded in a previous clock cycle.

Each time after a clock cycle, the weight data already loaded into the systolic array sinks by one row. Meanwhile, a row of weight data is newly loaded into the systolic array, and the row of weight data has one more column than the weight data load in a previous clock cycle. Therefore, after eight clock cycles, the weight data is located in the PEs from the 1^{st} to the 8^{th} rows of the 1^{st} column, the 1^{st} to the 7^{th} rows of the 2^{nd} column, the 1^{st} to the 6^{th} rows of the 3^{rd} column, the 1^{st} to the 5^{th} rows of the 4^{th} column, the 1^{st} to the 4^{th} rows of the5^{th} column, the 1^{st} to the 3^{rd} rows of the 6^{th} column, the 1^{st} and 2^{nd} rows of the 7^{th} column, and the 1^{st} row of the 8^{th} column of the systolic array, as shown by shaded PEs in FIG. 2.

The systolic array includes M rows and N columns of PEs. In one clock cycle, a new row of weight data is loaded into the systolic array, and the row of weight data has one more column than the weight data loaded in a previous clock cycle. In a case that a new row of N pieces of weight data is loaded into the systolic array in a clock cycle, a new row of N pieces of weight data would be also loaded into the systolic array in each clock cycle after such clock cycle. That is, a quantity of the pieces of weight data newly loaded in one clock cycle is not greater than the quantity of PEs in one row.

In a case that all PEs in the 1^{st} column of the systolic array are loaded with the weight data, the electronic device can read the feature-map data from the storage unit. In any clock cycle, the electronic device may load the feature-map data from the storage unit in response to the read request for reading the feature-map data. The feature-map data flows into the PEs in the 1^{st} column of the systolic array from an input side (for example, a left side) of the systolic array, and calculation is performed by the PEs in the 1^{st} column using the weight data in the PEs and the feature-map data flowing into the PEs. In all embodiments of the present disclosure, the PEs perform multiplication and/or addition on the weight data and the feature-map data.

Then, after the above clock cycle, the next clock cycle comes. The next clock cycle of the one clock cycle is treated as a current clock cycle at a current time. In the current clock cycle, the electronic device may load new weight data from the storage unit in response to the read request for reading the weight data. The weight data is inputted into the systolic array after passing through the triangularization array. In this case, the weight data that have already been loaded into the systolic array sinks by one row, and the new row of weight data is loaded into the systolic array such that all PEs in the 1^{st} column of the systolic array and all PEs in the 2^{nd} column of the systolic array are loaded with the weight data. The feature-map data loaded in the previous clock cycle flows into the PEs in the 2^{nd} column of the systolic array, and the weight data resident in these PEs and the feature-map data flowing into these PEs are subject to calculation using the PEs in the second column. At the same time, in the current clock cycle, the electronic device may load new feature-map data from the storage unit based on another read request for reading the feature-map data. The new feature-map data flows into the PEs in the 1^{st} column of the systolic array from the input side (for example, the left side) of the systolic array, and the weight data resident in these PEs and the feature-map data flowing into these PEs are subject to calculation using the PEs in the 1^{st} column. The subsequent clock cycles may be deduced by analogy.

That is, when all PEs in the 1^{st} column of the systolic array have been loaded with the weight data, in each clock cycle, the weight data already loaded into the systolic array sinks by one row, and the feature-map data already loaded into the systolic array is shifted rightward by one column. Meanwhile, a new row of weight data is loaded into the systolic array, and a new column of feature-map data is loaded into the systolic array. In addition, calculation is performed by each PE using the feature-map data currently flowing through such PE and the weight data currently flowing through such PE. Finally, the weight data flows out from a first output side (for example, a side adjacent to the input side, such as a lower side) of the systolic array, and the feature-map data flows out from a second output side (for example, a side opposite to the input side, such as a right side) of the systolic array.

Hence, after loading the weight data from the storage unit to all PEs in 1^{st} column of the systolic array, the electronic device can load the feature-map data from the storage unit into the PEs in 1^{st} column. It takes at least one clock cycle for the electronic device to load the weight data from the storage unit into all PEs in the 1^{st} column of the systolic array. In addition, only when calculation has been performed on the weight data resident in the PEs in the 1^{st} column of the systolic array and the feature-map data flowing into the PEs in the 1^{st} column, the electronic device would load weight data in the storage unit into the systolic array again. Therefore, there should be a time sequence for loading the weight data and loading the feature-map data.

Only when the weight data in the storage unit is loaded into the PEs in the 1^{st} column of the systolic array after at least one clock cycle, the feature-map data in the storage unit can be loaded into the systolic array. Only when calculation has been performed on the weight data in the PEs in the 1^{st} column of the systolic array and the feature-map data flowing into the PEs in the 1^{st} column, the feature-map data in the storage unit can be loaded into the systolic array again. In conventional technology, a queue is instantiated in the storage unit. When a data reading port (a port in the storage unit that is configured to input the feature-map data or the weight data into the systolic array) does not meet a condition for receiving data, i.e., when the feature-map data or the weight data in the storage unit cannot be loaded into the systolic array, data is first read from the storage unit in response to the read request and then registered in a queue. When the data reading port has met the condition for receiving data, i.e., when the feature-map data or the weight data in the storage unit can be loaded into the systolic array, the data is taken out from the queue and transmitted to the systolic array through the data reading port.

Since data in the storage unit includes the weight data and the feature-map data, a queue corresponding to the weight data and a queue corresponding to the feature-map data need to be instantiated. Considering the read delay, a depth of the queue needs to be greater than or equal to the read delay. For example, if the read delay is 10 clock cycles, the depth of the queue is at least 10. Such configuration can avoid data loss. When the amount of processed data increases, the read delay also increases, so that the two queues need to utilize a large number of registering resources. Accordingly, the chip has a large area.

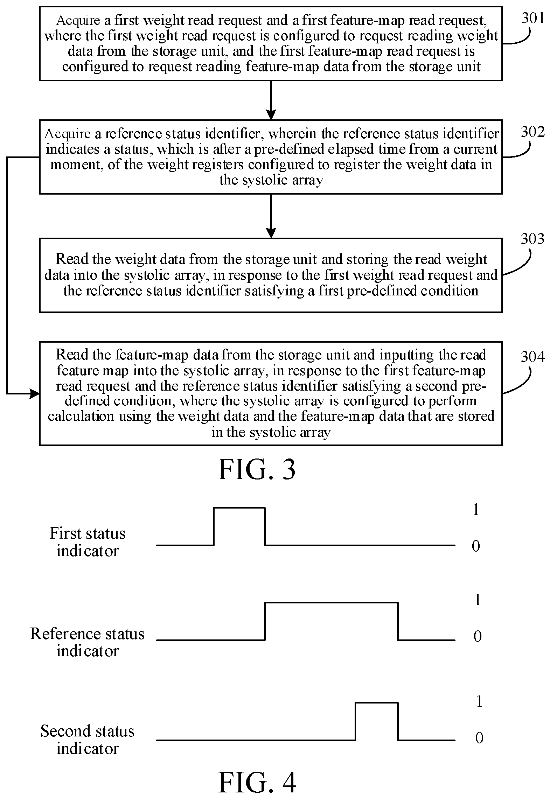

An embodiment of the present disclosure provides a data reading method. The method may be applied to the above-mentioned implementation environment and may reduce the chip area. Taking a flowchart of a data reading method according to an embodiment of the present disclosure as shown in FIG. 3 as an example, for the convenience of description, the terminal device 101 or the server 102 which performs the data reading method in the embodiments of the present disclosure is referred to as an electronic device. The method may be performed by the electronic device, in particular by a processor of the electronic device. The electronic device further comprises a systolic array and a storage unit that are connected to the processor, and the systolic array comprises weight registers. As shown in FIG. 3, the method includes the following steps.

Step 301: Acquire a first weight read request and a first feature-map read request, where the first weight read request is configured to request reading the weight data from the storage unit, and the first feature-map read request is configured to request reading feature-map data from the storage unit.

The data reading method in the embodiments of the present disclosure is applicable to the technical field of AI. In the technical field of AI, features of media are usually processed through a neural network model. The weight data may be a model parameter of the neural network model. As an example, in a layer of the neural network model, the weight data may characterize the magnitude of the contribution of a variable to a calculation result of the layer. The neural network model may be a feature extraction model configured to perform feature extraction on the media, or the neural network model may be a classification model configured to classify the media, or the like. The feature-map data may be a feature of the media. As an example, the media includes at least one of an image, text, audio, or the like. That is, the feature-map data may be at least one of an image feature, a text feature, an audio feature, or the like.

The electronic device may acquire the first weight read (wt_rd) request in any clock cycle, and the first weight read request is configured to request reading weight data. In addition, the electronic device may acquire the first feature-map read (fm_rd) request in any clock cycle, and the first feature-map read request is configured to request reading feature map (fm) data.

A temporal order of the first weight read request and the first feature-map read request is not limited in the embodiments of the present disclosure. That is, the first weight read request and the first feature-map read request may be acquired at the same time, or the first weight read request may be first acquired and then the first feature-map read request is acquired, or the first feature-map read request may be first acquired and then the first weight read request is acquired.

Step 302: Acquire a reference status identifier, where the reference status identifier indicates a predicted status of the weight registers in the systolic array at a first moment, the first moment is post to a current moment by a pre-defined elapsed time interval.

In all embodiments of the present disclosure, the electronic device may have an arbiter unit to coordinate the time sequence between the weight data and the feature-map data by maintaining a reference status register. The reference status register may be denoted as a weight occupy (wt_occupy) register and is configured to register the reference status identifier. As an example, the reference status identifier is denoted wt_occupy. The reference status identifier is configured to indicate the status of the weight registers in the systolic array after the pre-defined elapsed time from the current time. The weight registers are configured to register the weight data. The pre-defined elapsed time may be pre-defined duration calculated from a moment. In all embodiments of the present disclosure, the pre-defined elapsed time is a time interval between a first moment at which it is determined whether the reference status identifier satisfies a first pre-defined condition and a second moment at which the data corresponding to such condition enters the systolic array. The time interval between the first moment and the second moment may be identical to a time interval between a third moment at which it is determined whether the reference status identifier satisfies a second pre-defined condition and a fourth moment at which the data corresponding to such condition enters the systolic array. Since the clock frequency is known, the pre-defined elapsed time may be pre-configured accordingly.

Step 303: Read the weight data from the storage unit and storing the read weight data into the systolic array, in response to the first weight read request and the reference status identifier satisfying a first pre-defined condition.

When the electronic device acquires the reference status identifier from the reference status register, it is equivalent to obtaining the status of the weight registers after the pre-defined elapsed time. The status of the weight registers is either a) the weight registers are to register (new) weight data, or b) the weight registers are not to register (new) weight data. The systolic array runs according to a particular clock frequency. Therefore, whether the group weight registers in the systolic array would be in the status of "to register weight data" or the status of "not to register weight data" after the pre-defined elapsed time from the current time can be foretold the current time.

In all embodiments of the present disclosure, in a case that all PEs in the 1^{st} column of the systolic array are loaded with weight data, the weight registers may be determined as in the status of "not to register weight data". In a case that all or some of the PEs in the 1^{st} column of the systolic array are not loaded with weight data, the weight register may be determined as in the status of "to register weight data".

Additionally or alternatively, in a case that any PE in the fully loaded 1^{st} column of the systolic array is loaded with unused weight data, the weight registers may be determined as in the status of "not to register weight data". In a case that all PEs in the 1^{st} column of the systolic array are loaded with used weight data, the weight register is in the status of "to register weight data". The weight data in a PE is considered to be used in a case that the calculation has been performed using such weight data and feature-map data flowing through such PE. The weight data in a PE is considered to be unused in a case that no calculation has been performed using such weight data and feature-map data flowing through such PE.

For example, in a case that all or some of the PEs in the 1^{st} column of the systolic array do not have any weight data, the weight registers are in the status of "to register weight data". In a case that all PEs in the 1^{st} column of the systolic array have weight data and all or some of the PEs have unused weight data, the weight register is in the status "not to register weight data". In a case that all PEs in the 1^{st} column have used weight data, the weight register is in the status of "to register weight data".

Whether the reference status identifier satisfies the first pre-defined condition may be determined according to the status of these weight registers after the pre-defined elapsed time. Accordingly, it is determined whether the weight data can be loaded into the systolic array at the current time.

In all embodiments of the present disclosure, the first pre-defined condition in step 303 may be that the reference status identifier indicates that the weight registers is to register the weight data after the pre-defined elapsed time from the current moment.

There are two cases that may put the weight register in the status of "to register the weight data". A first case is that all or some of the PEs in the 1^{st} column of the systolic array have never received weight data. A second case is that all PEs in the 1^{st} column of the systolic array have received the weight data, but the weight data in all these PEs have been subject to calculation along with the feature-map data flowing through these Pes, that is, the weight data in these PEs has been used.

In a case that all or some of the PEs in the 1^{st} column of the systolic array do not have weight data, and/or the weight data of all PEs in the 1^{st} column of the systolic array has been used, the electronic device may load the weight data in the storage unit to the systolic array. Based on this principle, when the reference status identifier indicates that the weight register would be in the status of "to register weight data" after the pre-defined elapsed time from the current time, the electronic device determines that the reference status identifier satisfies the first pre-defined condition. Accordingly, the weight data stored in the storage unit can be read and stored into the systolic array at that time. Such operation enables all PEs in the 1^{st} column of the systolic array to be loaded with weight data and enables all or some of the PEs to be loaded with unused weight data.

When the reference status identifier indicates that the weight register would be in the status of "not to register weight data" after the pre-defined elapsed time from the current time, all PEs in the 1^{st} column of the systolic array would be loaded weight data and all or some of the PEs would be loaded unused weight data after the pre-defined elapsed time. The electronic device should not load the weight data from the storage unit into the systolic array after the pre-defined elapsed time. Based on this principle, the electronic device determines that the reference status identifier does not satisfy the first pre-defined condition, and the electronic device may ignore the first weight read request at the current time.

Step 304: Read the feature-map data from the storage unit and inputting the read feature map into the systolic array, in response to the first feature-map read request and the reference status identifier satisfying a second pre-defined condition, where the systolic array is configured to perform calculation using the weight data and the feature-map data that are stored in the systolic array.

Step 304 may be performed after step 302. Whether the reference status identifier satisfies the second pre-defined condition may be determined according to the status of the weight register after the pre-defined elapsed time, and thereby it is determined whether the feature-map data would be loaded to the systolic array.

In all embodiments of the present disclosure, performing the calculation using the weight data and the feature-map data that are stored in the systolic array may comprise following steps. Correspondence between the weight data and the feature-map data is determined according to a structure of a neural network model. The weight data and the feature-map data are organized to participate in the calculation of the neural network model according to the correspondence to obtain a calculation result. The calculation result may be an intermediate calculation result or may be a final result outputted by the neural network model.

In all embodiments of the present disclosure, the correspondence between a piece of the weight data and a piece of the feature-map data may be that the piece of weight data and the piece of feature-map data serve as inputs of a function in the neural network model, and an output of the function serves as the calculation result. The correspondence between the piece of weight data and the piece of feature-map data may be embodied as dot product multiplication.

In all embodiments of the present disclosure, the second pre-defined condition in step S304 may be that the reference status identifier indicates that the weight registers is not to register the weight data after the pre-defined elapsed time from the current time.

In a case that the reference status identifier indicates that the weight register is in the status of "not to register weight data" after the pre-defined elapsed time from the current time, all PEs in the 1^{st} column of the systolic array would be loaded with weight data while all or some of the Pes would be loaded unused weight data after the pre-defined elapsed time. The electronic device can load the feature-map data from the storage unit into the systolic array at that time. Based on this principle, when the reference status identifier indicates that the weight register is in the status of " "not to register weight data" after the pre-defined elapsed time from the current time, the electronic device determines that the reference status identifier satisfies the second pre-defined condition. Accordingly, the feature-map data stored in the storage unit can be load into the systolic array after the pre-defined elapsed time, and such operation enables all PEs in the 1^{st} column of the systolic array to perform the calculation on the weight data resident in these PEs and the feature-map data flowing through these PEs.

When the reference status identifier indicates that the weight register would be in the status of "to register weight data" after the pre-defined elapsed time from the current time, all or some of the PEs in the 1^{st} column of the systolic array would be loaded with no weight data and/or all PEs in the fully-loaded 1^{st} column of the systolic array has been used after the pre-defined elapsed time. The electronic device should not load the feature-map data into the storage unit to the systolic array after the pre-defined elapsed time. Based on this principle, the electronic device determines that the reference status identifier does not satisfy the second pre-defined condition, and the electronic device may ignore the first feature-map read request at the current time.

When the reference status identifier satisfies the first pre-defined condition, the weight data may be directly read and stored into the systolic array in response to the first weight read request, and the first feature-map read request is ignored. When the reference status identifier satisfies the second pre-defined condition, the feature-map data may be directly read and inputted into the systolic array in response to the first feature-map read request, and the first weight read request is ignored. Hence, the reference status identifier is subject to arbitration, which constructs a time sequence between loading the weight data and loading the feature-map data. Calculation of the systolic array using the weight data and the feature-map data is facilitated.

In all embodiments of the present disclosure, before step 304, the method may further comprise steps 306 and 307 (not shown in FIG. 3).

Step 306: Acquire a first status identifier, where the first status identifier indicates whether the plurality of weight register finishes registering the weight data of a first clock cycle after the pre-defined elapsed time from the current time, and the first clock cycle is a clock cycle has a temporal sequential number of n among clock cycles in which the weight data are read, and n is a preset integer.

In all embodiments of the present disclosure, the reference status identifier may be arbitrated through an arbiter unit. In a case that the reference status identifier satisfies the first pre-defined condition, the weight data is read and stored into the systolic array in response to the first weight read request. In a case that the reference status identifier does not satisfy the first pre-defined condition, the first weight read request is ignored.

Based on this, the arbiter unit may maintain a first status register that registers the first status identifier. When the first weight read request of any clock cycle is received by the arbiter unit, the first status identifier is set to a third value in a case that such clock cycle is the first clock cycle (hereinafter referred to as the n^{th} clock cycle), and the first status identifier is set to a fourth value in a case that the clock cycle is not the n^{th} clock cycle. A value of the first status identifier is the third value only in the n^{th} clock cycle, and the value of the first status identifier in other clock cycles is the fourth value. As an example, the first status identifier is denoted as wt_last_beat.

Changing the first status identifier from the third value to the fourth value indicates that the weight register would finish registering the weight data of the n^{th} clock cycle after the pre-defined elapsed time from the current time. Changing the first status identifier from the fourth value to the third value indicates that the weight registers would start registering the weight data of the n^{th} clock cycle after the pre-defined elapsed time from the current time.

The third value and the fourth value are specifically not limited in embodiments of the present disclosure. As an example, the third value is 1, and the fourth value is 0.

Step 307: Determine the reference status identifier to indicate that the weight registers is not to register the weight data after the pre-defined elapsed time from the current time, in response to the first status identifier indicating that the plurality of weight register finishes registering the weight data of the first clock cycle after the pre-defined elapsed time from the current time.

In a case that the first status identifier is changed from the third value to the fourth value, the weight registers would finish registering the weight data of the n^{th} clock cycle after the pre-defined elapsed time, which means that the weight registers are in the status of "not to register weight data" after the pre-defined elapsed time. In such case, the electronic device changes the reference status identifier from a first value to a second value. When the reference status identifier is the first value, the weight registers would be in the status of "to register weight data" after the pre-defined elapsed time. When the reference status identifier is the second value, the weight registers would be in the status of "not to register weight data" after the pre-defined elapsed time. The first value and the second value are not specifically limited in embodiments of the present disclosure. As an example, the first value is 0, and the second value is 1.

Referring to FIG. 4, FIG. 4 is a schematic diagram of updating a status identifier according to an embodiment of the present disclosure. It can be seen from FIG. 4 that, in response to the first status identifier being changed from 1 (i.e., the third value) to 0 (i.e., the fourth value), the reference status identifier is changed from 0 (i.e., the first value) to 1 (i.e., the second value).

In all embodiments of the present disclosure, the method may further comprise step 308 to step 309 (not shown in FIG. 3). Step 308 to step 309 may be performed after step 307.

Step 308: Acquire a second status identifier, where the second status identifier indicates whether calculation is performed on the weight data in the weight registers and the feature-map data, of a second clock cycle, after the pre-defined elapsed time from the current time, and the second clock cycle is an earliest clock cycle of reading the feature-map data from the storage unit after the reference status identifier indicates that the weight registers is not to register the weight data.

When the feature-map read request of any clock cycle is received by the arbiter unit, the feature-map data indicated by the feature-map read request and the weight data registered in the weight registers would be subject to calculation of the systolic array after the pre-defined elapsed time, in a case that the second pre-defined condition is satisfied. Based on this, the arbiter unit may maintain a second status register that registers the second status identifier. When a feature-map read request of any clock cycle is received by the arbiter unit, the second status identifier is set to a fifth value in a case that the clock cycle is the second clock cycle (hereinafter referred to as the 1^{st} feature-data clock cycle), and the second status identifier is set to a sixth value in a case that the clock cycle is not the 1^{st} feature-data clock cycle. A value of the second status identifier is the fifth value only in the second clock cycle, and a value of the second status identifier in other clock cycles is the sixth value. As an example, the second status identifier may be denoted as fm_update_first_beat.

Changing the second status identifier from the fifth value to the sixth value indicates that the calculation on the weight data in the weight registers and the feature-map data read in the 1^{st} feature-data clock cycle would finish after the pre-defined elapsed time from the current time. Changing the second status identifier from the sixth value to the fifth value indicates that the calculation on the weight data in the weight registers and the feature-map data read in the 1^{st} feature-data clock cycle would start after the pre-defined elapsed time from the current time.

The fifth value and the sixth value are not limited in embodiments of the present disclosure. As an example, the fifth value is 1, and the sixth value is 0.

Step 309: Determine the reference status identifier to indicate that the weight registers is to register the weight data after the pre-defined elapsed time from the current time, in response to the second status identifier indicating that the calculation is performed on the weight data in the weight registers and the feature-map data of the second clock cycle after the pre-defined elapsed time from the current time.

When the second status identifier is changed from the fifth value to the sixth value, the calculation on the weight data in the weight registers and the feature-map data read in the 1^{st} feature-data clock cycle would finish after the pre-defined elapsed time. In such case, the electronic device sets the reference status identifier from the second value to the first value. It can be seen from FIG. 4 that, in response to the second status identifier being changed from 1 (i.e., the fifth value) to 0 (i.e., the sixth value), the reference status identifier is changed from 1 (i.e., the second value) to 0 (i.e., the first value).

In summary, an initial value of the reference status identifier is the first value, characterizing that the weight register is in the status of "to register weight data" after the pre-defined elapsed time from the current time. At the same time, the reference status identifier satisfies the first pre-defined condition. Hence, the weight data stored in the storage unit can be read and stored into the systolic array in response to the first weight read request, and the first feature-map read request is ignored even when acquired. The above stage lasts for several clock cycles until the reference status identifier is set from the first value to the second value.

The reference status identifier being the second value represents that the weight register is in the status of "not to register weight data". In such case, the reference status identifier satisfies the second pre-defined condition. Hence, in one clock cycle, the feature-map data stored in the storage unit is read and inputted into the systolic array in response to the first feature-map read request, and the first weight read request is ignored when acquired. After such clock cycle, the reference status identifier is set from the second value to the first value. Then process proceeds to option A or option B.

In option A, the reference status identifier is the first value at first. In a next clock cycle, the weight data stored in the storage unit may be read and stored into the systolic array in response to the first weight read request, and the first feature-map read request is ignored. After such clock cycle, the reference status identifier is set again from the first value to the second value. In a next clock cycle, the feature-map data stored in the storage unit may be read and inputted into the systolic array in response to the first feature-map read request, and the first weight read request is ignored. After such clock cycle, the reference status identifier is set again from the second value to the first value. The above operations are repeated until reading is stopped.

In option B, the reference status identifier is the first value, and then the process proceeds to step 310 and step 311 (not shown in FIG. 3). Step 310 and step 311 may be performed after step 304 or after the operation of "changing the reference status identifier from the second value to the first value".

Step 310: Acquire a second weight read request and a second feature-map read request, where the second weight read request is configured to request reading the weight data from the storage unit, and the second feature-map read request is configured to request reading the feature-map data from the storage unit.

The electronic device may further acquire the second weight read request in any clock cycle, and the second weight read request is configured for reading the weight data. The electronic device may further acquire the second feature-map read request in any clock cycle, and the second feature-map read request is configured for reading the feature-map data. The electronic device may acquire the second weight read request and the second feature-map read request at the same time, may first acquire the second weight read request and then acquire the second feature-map read request, or may first acquire the second feature-map read request and then acquire the second weight read request.

Step 311: read the weight data stored from the storage unit and storing the read weight data into the systolic array in response to the second weight read request, and read the feature-map data from the storage unit and inputting the read feature-map data into the systolic array, in response to the second feature-map read request, where both a read delay of the weight data and a read delay of the feature-map data are equal to the pre-defined elapsed time.

Since the read delay of the weight data and the read delay of the feature-map data are equal to pre-defined elapsed time, the read delay of the weight data is equal to the read delay of the feature-map data. At such stage, each time the weight data of one clock cycle is loaded into the systolic array, the feature-map data of one clock cycle flows corresponding into the systolic array, and calculation is performed on such weight data resident in the systolic array and such feature-map data. Thereby, the time sequence of loading the weight data and loading the feature-map data can be inherently maintained. Based on this, the weight data stored in the storage unit can be directly read and stored into the systolic array in response to the second weight read request, and the feature-map data stored in the storage unit can be read and inputted into the systolic array in response to the second feature-map read request, without determining whether the reference status identifier satisfies the first pre-defined condition or the second pre-defined condition.

When the read delay of the weight data is equal to the read delay of the feature-map data, the time sequence of loading the weight data and loading the feature-map data can be maintained. Hence, it is not necessary to utilize queue(s) to register data, which saves occupation of registering resources required by the queue(s) and facilitates decreasing the chip area. In addition, the corresponding data is directly read in response to the second weight read request and the second feature-map read request without determining whether the reference status identifier satisfies the first pre-defined condition or the second pre-defined condition. Thus, efficient switching between the weight read request and the feature-map read request can be realized, which improves data reading efficiency and reduces computation time.

In all embodiments of the present disclosure, the first weight read request may comprise at least one first weight sub-request, and the storage unit comprises at least one first storage block. For example, the first weight read request comprises four first weight sub-requests, which are denoted as req0 to req3, respectively, and the storage unit comprises four first storage blocks, which are denoted as bg0 to bg3, respectively.

Step 303 of reading the weight data from the storage unit and storing the read weight data into the systolic array may comprise following step 3031 to step 3032 (not shown in FIG. 3) for each first weight sub-request.

Step 3031: In a case that such first weight sub-request is determined to be a valid request, determine a respective first storage block for (e.g., requested by) such first weight sub-request and read the weight data for such first weight sub-request from the respective first storage block.

The electronic device may directly determine the first weight sub-request as the valid request, or the electronic device may compare the first weight sub-request with a reference first weight sub-request and determine whether the first weight sub-request is the valid request according to a comparison result.

In all embodiments of the present disclosure, step 3031 may comprise following sub-steps. An address of the respective first storage block for such first weight sub-request is extracted from such first weight sub-request. Such first weight sub-request is determined to be the valid request, in a case that the address of the respective first storage block for such first weight sub-request is different from an address of the respective first storage block for the reference first weight sub-request. The reference first weight sub-request comprises one or more first weight sub-requests other than such first weight sub-request.

Each first weight sub-request may comprise a flag bit and the address. The flag bit is configured to indicate inherent validity of the first weight sub-request, and the address is a storage address of data requested by the first weight sub-request.

The data requested the first weight sub-request needs to be read from the storage unit. Since the storage unit comprises at least one first storage block, the first weight sub-request comprises the address of the first storage block, such that the weight data requested by the first weight sub-request can be read from the first storage block.

Each first weight sub-request comprises the address of the respective first storage block. Two first weight sub-requests may comprise the address of the same first storage block or may comprise the addresses of different first storage blocks. Based on this, it is required to determine whether two first weight sub-requests comprise the address of the same first storage block.

In all embodiments of the present disclosure, since each first weight sub-request comprises the address of the respective first storage block, the address of the respective first storage block may be extracted from the first weight sub-request. The address of the respective first storage block of the first weight sub-request is compared with an address of the respective first storage block of the reference first weight sub-request. In a case that the comparison result is that the two addresses are different, it is determined that such first weight sub-request is the valid request. In a case that the comparison result is that the two addresses are the same, it is determined that such first weight sub-request is an invalid request.

There is at least one reference first weight sub-request. When there are two or more reference first weight sub-requests, such first weight sub-request is determined to be the valid request in a case that the address of the respective first storage block of such first weight sub-request is different from all addresses of the respective first storage blocks of the reference first weight sub-requests. Otherwise, such first weight sub-request is determined to be the invalid request in a case that the address of the respective first storage block of any reference first weight sub-request is the same as the address of the respective first storage block of such first weight sub-request, it is determined that the.

A manner for determining the reference first weight sub-request is not limited in embodiments of the present disclosure. As an example, all first weight sub-request(s) except such first weight sub-request serve as the reference first weight sub-request(s). Alternatively, all first weight sub-request(s) located sequenced before (or after) such first weight sub-request serve as the reference first weight sub-request(s).

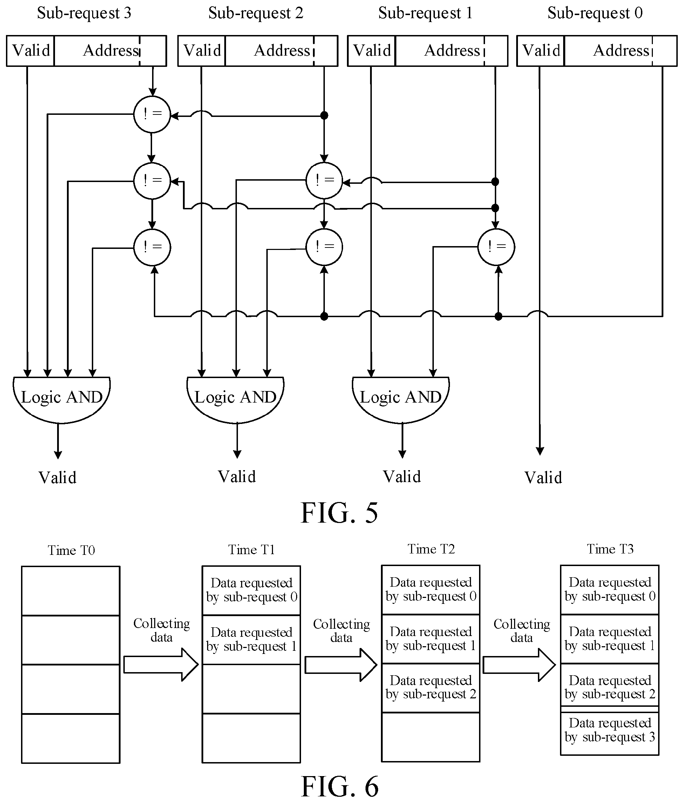

Referring to FIG. 5, FIG. 5 is a schematic diagram of determining whether a sub-request is valid according to an embodiment of the present disclosure. It is assumed that the first weight read request comprises four first weight sub-requests denoted as sub-request 0 to sub-request 3, respectively. Each first weight sub-request comprises a flag bit configured to indicate that the inherent validity of the first weight sub-request and an address at which the data requested by first weight sub-request is stored. All or a part of the address in the first weight sub-request is an address of the respective first storage block. For example, FIG. 5 shows that sub-request 0 to sub-request 3 each comprises a flag bit indicating "valid" and an address, and a part of the address is the address of the respective first storage block.

The electronic device may determine the validity of the sub-request 0 directly. For example, the electronic device directly determines that the sub-request 0 is the valid request.

For sub-request 1, the electronic device may compare the address of the respective first storage block of sub-request 0 with the address of the respective first storage block of sub-request 1. When the comparison result is the two addresses being different (where "! =" is a computer symbol indicating that the two variables are not equal) and the flag bit of the sub-request 1 indicates that it is inherently valid, a logic AND operation performed on the comparison result and the flag bit indicates that that sub-request 1 is valid. The result of the logic AND operation is true when two operands are both true. When the comparison result shows that the two addresses are different, the operand corresponding to the comparison result indicates that sub-request 1 is valid and hence is true. The flag bit of the sub-request 1 indicates that the sub-request 1 is inherently valid and hence is also true. Thus, the result of the logic AND operation is true, that is, the final result is that the sub-request 1 is valid.

In a case that the comparison result shows that the two addresses are the same and the flag bit of the sub-request 1 indicates that it is inherently valid, the logic AND operation performed on the comparison result and the flag bit indicates that the sub-request 1 is invalid. When the comparison result is that the two addresses are the same, the operand corresponding to the comparison result indicates that the sub-request 1 is invalid.

For sub-request 2, based on a principle similar to that of sub-request 1, an address of the respective first storage block of sub-request 2 may be compared with addresses of the respective first storage blocks of sub-requests 0 and 1. In a case that both comparison results are the addresses being different and the flag bit of the sub-request 2 indicates that it is inherently valid, the logic AND operation performed on the comparison results and the flag bit indicates that sub-request 2 is valid. In a case that either comparison result shows that the addresses being identical and the flag bit of the sub-request 2 indicates that it is inherently valid, the logic AND operation performed on the comparison results and the flag bit indicates that sub-request 2 is invalid.

For sub-request 3, based on a principle similar to that of sub-request 1, an address of the respective first storage block of sub-request 3 may be compared with addresses of the respective first storage blocks of sub-requests 0, 1, and 2. In a case that all three comparison results are the addresses being different and the flag bit of the sub-request 3 indicates that it is inherently valid, the logic AND operation performed on the comparison results and the flag bit indicates that sub-request 3 is valid. In a case that either comparison result shows that the addresses being identical and the flag bit of the sub-request 3 indicates that it is inherently valid, the logic AND operation performed on the comparison results and the flag bit indicates that sub-request 3 is invalid.

In all embodiments of the present disclosure, for each first weight sub-request, the flag bit of such first weight sub-request may indicate such first weight sub-request being valid in a cast that it has a seventh value, and the flag bit may indicate such first weight sub-request being invalid in a cast that it has an eighth value. The seventh value and the eighth value are not limited in embodiments of the present disclosure. As an example, the seventh value is 1, and the eighth value is 0.

Since each first weight sub-request comprises the address of the respective first storage block, the first storage block of each first weight sub-request can be determined based on the address of the first storage block in such first weight sub-request, and the data requested by the first weight sub-request can thus be read from the first storage block.

In all embodiments of the present disclosure, each first storage block may comprise at least one second storage block. For example, first storage block 0 comprises second storage blocks 0 and 1, first storage block 1 comprises second storage blocks 0 and 1, first storage block 2 comprises second storage blocks 0 and 1, and first storage block 3 comprises second storage blocks 0 and 1. Since each first storage block comprises at least one second storage block, the second storage block may be called a bank, and the first storage block may be called a bank group.

Step 3031 of reading the weight data for each first weight sub-request from the respective first storage block may comprise following sub-steps. A respective second storage block for such first weight sub-request. The weight data for such first weight sub-request is read from the respective second storage block.

Since each first weight sub-request comprises the address of the first storage block and each first storage block comprises at least one second storage block, the first weight sub-request may comprise an address of the respective second storage block. The respective second storage block of each first weight sub-request can be determined based on the address of the second storage block in such first weight sub-request, and the weight data requested by the first weight sub-request can be read from the respective second storage block.

Step 3032: Transmit the weight data for such first weight sub-request to the systolic array.

The electronic device needs to determine whether the first weight sub-request(s) in the first weight read request are valid requests, and the data requested by the first weight sub-request can be read only when the first weight sub-request is valid request. Hence, there is a difference among the moments at which reading of the data requested by the first weight sub-requests is finished. The data requested by the first weight sub-requests may thus be collected by an acquisition unit. After acquiring the data of the first weight sub-requests, the acquisition unit exports the data of the first weight sub-requests from the storage unit as the weight data requested by the first weight read request according to an exporting command (for example, a reg command). Then, the weight data is transmitted to the systolic array.

Referring to FIG. 6, FIG. 6 is a schematic diagram of a data acquisition process according to an embodiment of the present disclosure. It is assumed that the first weight read request comprises four first weight sub-requests, which are sub-requests 0 to 3, respectively. At time T0, the acquisition unit has not acquired data requested by any first weight sub-request. At time T1, the acquisition unit has acquired data requested by sub-requests 0 and 1. At time T2, the acquisition unit has acquired data requested by sub-requests 0 to 2. At time T3, the acquisition unit has acquired data requested by sub-requests 0 to 3. Then, the data requested by sub-requests 0 to 3 is exported from the storage unit according to the export command and serves as the weight data requested by the first weight read request.

Similarly, the first feature-map read request may comprise at least one first feature map sub-request, the second weight read request may comprise at least one second weight sub-request, and the second feature-map read request may comprise at least one second feature map sub-request. The operation of reading the feature-map data from the storage unit and inputting the read feature-map data into the systolic array in response to the first feature-map read request, the operation of reading the weight data stored in the storage unit and storing the read weight data into the systolic array in response to the second weight read request, and the operation of reading the feature-map data from the storage unit and inputting the read feature-map data into the systolic array in response to the second feature-map read request may refer to the foregoing descriptions of step 3031 to step 3032. These operations are implemented in a similar manner, and details are not described herein again.

In all embodiments of the present disclosure, the method may further comprise step 312 to step 313 (not shown in FIG. 3).

Step 312: Acquire a write request.

The electronic device may acquire the write request in any clock cycle. The write request is configured to write the weight data or the feature-map data into the storage unit. The write request may be a direct memory access (DMA)-based data-migration write (wr) request and is configured to migrate data from other memories to the storage unit. As an example, the write request may be denoted as a dma_wr request.

Step 313: Write the weight data or the feature-map data, which is indicated by the write request, into the storage unit.

In all embodiments of the present disclosure, the write request may comprise at least one third sub-request, and the storage unit may comprise at least one first storage block. For example, the write request comprises four third sub-requests, and the storage unit comprises four first storage blocks.

In such case, step 313 may comprise following sub-steps for each third sub-request. A respective first storage block for such third sub-request is determined. The weight data or the feature-map data indicated by such third sub-request is written into the respective first storage block.

In all embodiments of the present disclosure, each third sub-request may comprise the address of the respective first storage block. Therefore, the respective first storage block for the third sub-request can be determined based on the address of the first storage block in the third sub-request, and the weight data or the feature-map data for the third sub-request can be written into the first storage block for the third sub-request.

In all embodiments of the present disclosure, each first storage block may comprise at least one second storage block. The step of writing data indicated by each third sub-request into the respective first storage block of such third sub-request in response to such third sub-request may comprise following sub-steps. A second storage block for each third sub-request is determined in response to such third sub-request. The data indicated by such third sub-request is written into the respective second storage block of such third sub-request.

Since each third sub-request comprises the address of the first storage block, and the first storage block comprises at least one second storage block, each third sub-request may comprise the address of the respective second storage block. The respective second storage block of the third sub-request can be determined based on the address of the second storage block in such third sub-request, and the data indicated by the third sub-request is written into the second storage block of the third sub-request.

Since the electronic device may receive the write request, the feature-map read request, and the weight read request, priorities of the various requests may be coordinated through a scheduler. In all embodiments of the present disclosure, the scheduler may be a strict priority (SP) scheduler.

The weight data and the feature-map data follow a particular time sequence. Hence generally, after the weight data is loaded into all PEs in the 1^{st} column of the systolic array, the feature-map data needs to be loaded into the systolic array first, and the weight data would be loaded into the systolic array again after calculation has been performed using the feature-map data inputted into the systolic array and the weight data resident in the systolic array. Based on the foregoing content, a priority of a (first or second) weight read request is lower than a priority of a (first or second) feature-map read request. A priority of the write request may be higher or lower than the priority of the weight read request and may be higher or lower than the priority of the feature-map read request. As an example, the priority of the feature-map read request is higher than the priority of the weight read request, and the priority of the weight read request is higher than the priority of the write request.

The priorities of various requests are coordinated through the scheduler so that data can be read and written in an order, thereby realizing efficient switching among multiple requests, and improving efficiency of data processing.

The information (including, but not limited to, user device information, user personal information, and the like), data (including, but not limited to, data for analysis, stored data, displayed data, and the like), and signals involved in the present disclosure all are authorized by the user or fully authorized by each party, and the acquisition, use, and processing of relevant data need to comply with relevant laws and regulations of relevant regions. For example, first data, second data, third data, etc., referred to in the present disclosure are all acquired under full authorization.

In the foregoing method, the status of the weight register in the systolic array is indicated by the reference status identifier. The weight data stored in the storage unit is read and stored into the systolic array in response to the first weight read request, in a case that the reference status identifier satisfies the first pre-defined condition. The feature-map data stored in the storage unit is read and inputted into the systolic array in response to the first feature-map read request, in a case that the reference status identifier satisfies the second pre-defined condition. The reference status identifier requires fewer registering resources relative to the registering resources required by the queues. The method is applicable to a chip. The fewer the registering resources are used, the smaller the chip area can be. Therefore, the apparatus in the chip facilitates reducing the chip area.

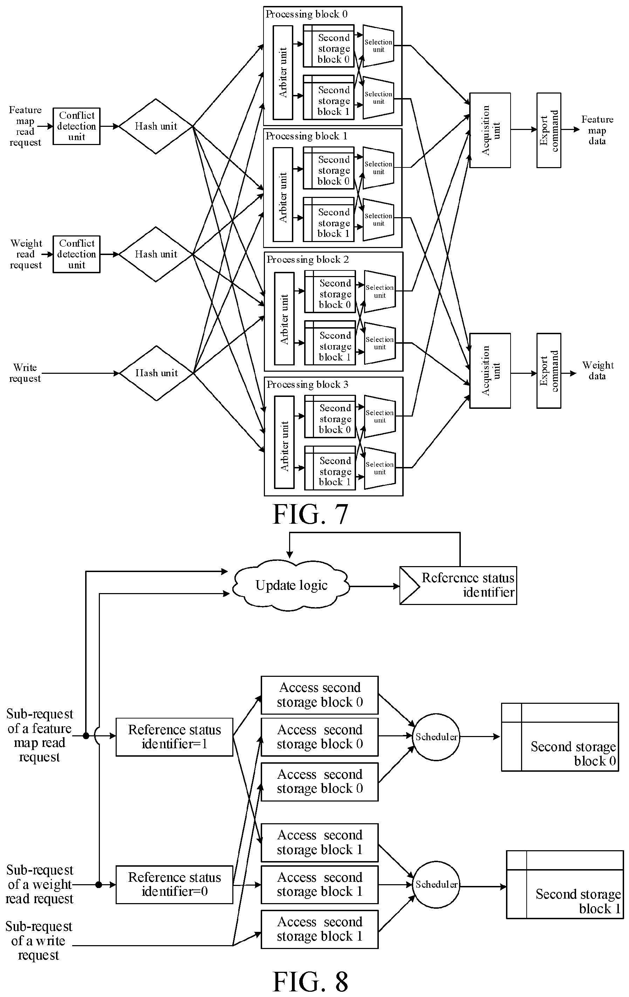

The foregoing describes the data reading method according to the embodiments of the present disclosure from a perspective of operations of the method. The following is a systematic and comprehensive description. Referring to FIG. 7, FIG. 7 is an architectural diagram of a storage system according to an embodiment of the present disclosure. The storage system includes conflict detection units, hash units, at least one processing block, and acquisition units, and each processing block comprises an arbiter unit, at least one second storage block, and selection units.

The storage unit and the first storage block are not shown in FIG. 7. Herein one first storage block includes second storage blocks of the same processing block, i.e., one processing block corresponds to one first storage block, and the storage unit comprises the first storage blocks. As shown in FIG. 7, the storage unit comprises a first storage block corresponding to processing block 0, a first storage block corresponding to processing block 1, a first storage block corresponding to processing block 2, and a first storage block corresponding to processing block 3. The first storage block corresponding to processing block 0 comprises second storage blocks 0 and 1 in the processing block 0. The first storage block corresponding to processing block 1 comprises second storage blocks 0 and 1 in processing block 1. The first storage block corresponding to the processing block 2 comprises second storage blocks 0 and 1 in processing block 2. The first storage block corresponding to processing block 3 comprises second storage blocks 0 and 1 in the processing block 3.

Herein the electronic device may read the feature-map data from the storage unit in response to the feature-map read request or may read the weight data from the storage unit in response to the weight read request. A manner for processing the feature-map read request is similar to a manner for processing the weight read request. Taking the feature-map read request as an example, the manner for processing the feature-map read request is as follows.

After acquiring the feature-map read request (corresponding to the foregoing first feature-map read request and the foregoing second feature-map read request), the electronic device performs conflict detection on the feature-map read request through the conflict detection unit. A principle of the conflict detection is as shown in FIG. 5. Herein the feature-map read request includes sub-request 0 to sub-request 3. Sub-request 0 is directly determined to be valid. Sub-request 1 is determined to be valid when the address of the respective first storage block of sub-request 0 is different from the address of the respective first storage block of sub-request 1. Otherwise, sub-request 1 is determined to be invalid. Sub-request 2 is determined to be valid when the addresses of the respective first storage blocks of sub-requests 0 and 1 are both different from the address of the respective first storage block of sub-request 2. Otherwise, sub-request 2 is determined to be invalid. Sub-request 3 is determined to be valid when the addresses of the respective first storage blocks of sub-requests 0 to 2 are all different from the address of the respective first storage block of sub-request 3. Otherwise, sub-request 3 is determined to be invalid.

After conflict detection has been performed on the feature-map read request, validity of the sub-requests in the feature-map read request are known. For each sub-request that is valid, the respective first storage block of such sub-request is determined based on the address of the first storage block through the hash unit, and a request path of the processing block in which the first storage block of such sub-request is located is set to be valid so that such sub-request can reach the first storage block. For each sub-request that is invalid, the request path of the processing block in which the first storage block of sub-request is located is set to be invalid by the hash unit, such that sub-request is prevented from reaching the first storage block.

For example, sub-request 0 corresponds to first storage block 0, and processing block 0 comprises first storage block 0. When sub-request 0 is valid, the request path of processing block 0 is set to be valid through the hash unit, so that sub-request 0 reaches first storage block 0. When sub-request 0 is invalid, the request path of processing block 0 is set to be invalid through the hash unit, so that the sub-request 0 is prevented from reaching first storage block 0.

Herein the storage system may comprise at least one processing block, and the processing block comprise an arbiter unit, a first storage block (not shown in the figure), and selection units, and the first storage block comprises at least one second storage block. A schematic structural diagram of the arbiter unit may refer to FIG. 8.

After each sub-request of the feature-map read request is inputted into the corresponding processing block, the sub-request is first arbitrated through the arbiter unit. As shown in FIG. 8, the arbiter unit is configured with an update logic of the reference status identifier, and the update logic is shown in FIG. 4.

As an example, initial values of the reference status identifier, the first status identifier, and the second status identifier are all 0. In the 1^{st} clock cycle, the electronic device may read the weight data from the storage unit and load the weight data into the weight register of the systolic array after the pre-defined elapsed time. In a case that the weight register would be in the status of "to register weight data" after the pre-defined elapsed time, the electronic device further reads the weight data from the storage unit in the 2^{nd} clock cycle and would load the weight data into the weight registers of the systolic array after the pre-defined elapsed time. This loading manner lasts for several clock cycles until the weight register would be in the status of "not to register weight data" after the pre-defined elapsed time. The last clock cycle of the above stage is the n^{th} clock cycle. That is, in the n^{th} clock cycle, the electronic device reads the weight data from the storage unit and would load the weight data into the weight registers of the systolic array after the pre-defined elapsed time. After that, the weight register is in the status of "not to register weight data".

When a sub-request of the weight read request in the n^{th} clock cycle flows into the arbiter unit, the first status identifier may be changed from 0 to 1. When the sub-request flows out of the arbiter unit, the first status identifier may be changed from 1 to 0. When the first status identifier is changed from 1 to 0, it indicates that the weight registers would finish registering the weight data of the n^{th} clock cycle after the pre-defined elapsed time. Hence, the reference status identifier is changed from 0 to 1.

The weight register finishing registering the weight data of the n^{th} clock cycle indicates that the weight register is in the status of "not to register weight data". Hence afterwards, the electronic device may read the feature-map data from the storage unit in any clock cycle, and after the pre-defined elapsed time, the feature-map data would flow into the systolic array and is subject to calculation along with the weight data in the weight register. Such clock cycle is the 1^{st} clock cycle in which the feature-map data is read.

When a sub-request of a feature-map read request in such 1^{st} clock cycle flows into the arbiter unit, the second status identifier may be changed from 0 to 1. When the sub-request flows out of the arbiter unit, the second status identifier may be changed from 1 to 0. When the second status identifier is changed from 1 to 0, it indicates that the weight data of the calculation using the weight register and the feature-map data of the 1^{st} clock cycle would finish after the pre-defined elapsed time. Hence, the reference status identifier is changed from 1 to 0.

In summary, the reference status identifier is first change from 0 to 1 and then is changed from 1 to 0. When any sub-request of any feature-map read request is arbitrated through the arbiter unit, the reference status identifier may be acquired. In a case that the reference status identifier is equal to 1, it is determined that the sub-request satisfies the second pre-defined condition, the second storage block which the sub-request accesses is determined based on the address carried by the sub-request, and the sub-request is transmitted to the second storage block through the scheduler. In a case that the reference status identifier is equal to 0, it is determined that the sub-request does not satisfy the second pre-defined condition, and the sub-request is ignored. For example, in a case that the sub-request satisfies the second pre-defined condition and the sub-request tries to access second storage block 0, the sub-request is transmitted to second storage block 0 through the scheduler. In a case that the sub-request satisfies the second pre-defined condition and the sub-request tries to access the second storage block 1, the sub-request is transmitted to second storage block 1 through the scheduler.

Afterwards, for each sub-request of the feature-map read request, the data requested by the sub-request is read from the respective second storage block of the sub-request through the selection unit. The data requested by the sub-requests is collected through the acquisition unit. The acquisition process may refer to the description for FIG. 6, and details are not described herein again. Since the acquisition unit acquires the data requested by the sub-requests of the feature-map read request, the feature-map data requested by the feature-map read request is acquired. Then, the feature-map data is inputted into the systolic array through the export command.

When the sub-requests of the feature-map read request of one clock cycle are arbitrated through the arbiter unit, arbitration results of the sub-requests are the same. Based on this, after the feature-map read request of one clock cycle is arbitrated through the arbiter unit, the feature-map read request may be inputted into the conflict detection unit for the foregoing processing. In this case, the sub-requests of the feature-map read request may be arbitrated through the arbiter unit in the processing block. Alternatively, the processing block may not include the arbiter unit. That is, the sub-requests of the feature-map read request may be directly transmitted to a corresponding second storage block through the hash unit, or the sub-requests of the feature-map read request may be directly transmitted to a corresponding scheduler through the hash unit and transmitted to the corresponding second storage block after being scheduled by the scheduler.

Similar processing may be performed on the weight read request according to the above-mentioned manner for processing the feature-map read request. When any sub-request of the weight read request is arbitrated through the arbiter unit, if the reference status identifier is equal to 0, it is determined that the sub-request satisfies the first pre-defined condition, a second storage block which the sub-request assessed is determined based on an address carried by the sub-request, and the sub-request is transmitted to the corresponding second storage block through the scheduler. In a case that the reference status identifier is equal to 1, it is determined that the sub-request does not satisfy the first pre-defined condition, and the sub-request is ignored.

Usually, the sub-request of the weight read request (corresponding to the foregoing first weight read request) is received under the first pre-defined condition in each of the first several clock cycles through the arbiter unit. As time passes, when it is determined through the arbiter unit that the sub-request of the weight read request does not satisfy the first pre-defined condition, the sub-request of the feature-map read request (corresponding to the foregoing first feature-map read request) is received under the second pre-defined condition through the arbiter unit. Once the reference status indicator is determined to satisfy the second pre-defined condition through the arbiter unit, subsequent reading of the weight data and subsequent reading of the feature-map data may not be arbitrated through the arbiter unit when the read delay of the weight data is the same as the read delay of the feature-map data. That is, the sub-request of the subsequent weight read request (corresponding to the foregoing second weight read request) and the sub-request of the feature-map read request (corresponding to the foregoing second feature-map read request) may not be arbitrated through the arbiter unit. This is because the read delay of the weight data and the read delay of the feature-map data are both referring to clock cycles. Therefore, each time the weight data of one clock cycle is loaded into the systolic array, the feature-map data of one clock cycle flows into the systolic array correspondingly, and calculation is performed using such feature-map data and the weight data resident in the systolic array. Hence, the time sequence of between loading the weight data and loading the feature-map data can be maintained, and arbitration of the arbiter unit is not necessary.

Herein the electronic device may write the feature-map data and/or the weight data into the storage unit in response to the write request. A manner for processing the write request is described as follows.

The write request comprises at least one sub-request (corresponding to the foregoing third sub-request). For each sub-request, the respective first storage block corresponding to such sub-request is determined based on the address of the first storage block through the hash unit, and a request path of the processing block in which the first storage block is located is set to be valid, so that the sub-request can reach the corresponding first storage block. In a case that the sub-request is invalid, the request path of the processing block in which the first storage block corresponding to the sub-request is located is set to be invalid through the hash unit, such that the sub-request is prevented from reaching the corresponding first storage block. The second storage block which the sub-request accesses may be determined based on the address carried by the sub-request, and the sub-request is transmitted to the corresponding second storage block through the scheduler to write the data indicated by the sub-request into the second storage block.

Since the scheduler may receive the sub-request of the feature-map read request, the sub-request of the weight read request, and the sub-request of the write request, priorities of various sub-requests may be configured. As an example, a priority of the sub-request of the feature-map read request is higher than a priority of the sub-request of the weight read request, and the priority of the sub-request of the weight read request is higher than a priority of the sub-request of the write request. The scheduler transmits various sub-requests to the second storage block in an order based on the priorities of various sub-requests.

Herein whether the sub-request of the feature-map read request satisfies the second pre-defined condition or whether the sub-request of the weight read request satisfies the first pre-defined condition may be determined through the arbiter unit according to the reference status identifier. When the corresponding condition is satisfied, the data requested by the sub-request is read from the second storage block. The reference status identifier requires fewer registering resources in view of the registering resources required by the queues, which facilitates reducing the chip area.

A memory access system with a read delay of 6 and a read data width of 2 kilobit (kb) is taken as an example. In the related art, two queues with a depth of 6 and a width of 2 kb need to be provided. One queue is configured to register the weight data, the other queue is configured to register the feature-map data, and the two queues need to consume registers of 24 kb. Compared with the chip area required in the related art, the chip area required in embodiments of the present disclosure can be reduced by 29491.2 square microns (um2).

In addition, when the sub-request of the weight read request is received under the first pre-defined condition or the sub-request of the feature-map read request is received under the second pre-defined condition, corresponding data may be directly read. When the sub-request does not satisfy such condition, the sub-request is ignored. The sub-request is arbitrated through the arbiter unit, thereby facilitating the construction of the time sequence between loading the weight data and loading the feature-map data. Atter the sub-request of the feature-map read request is received under the second pre-defined condition through the arbiter unit, subsequent reading of the weight data and reading of the feature-map data may not be arbitrated through the arbiter unit as long as the read delay of the weight data is the same as the read delay of the feature-map data, that is, the corresponding data is read directly. The time sequence between loading the weight data and loading the feature-map data can still be maintained. Based on the foregoing content, efficient switching among multiple requests can be realized, which facilitates improving efficiency of data reading.

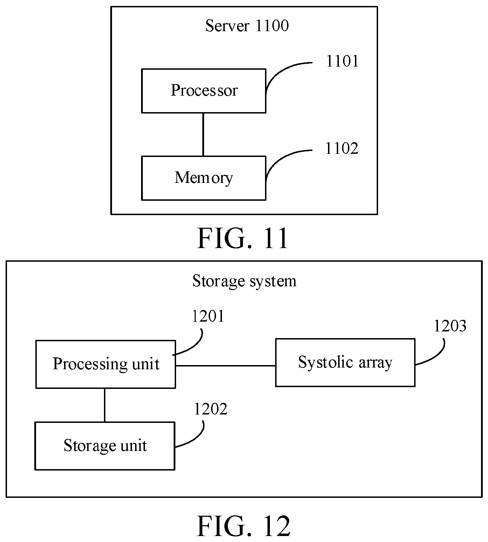

Referring to FIG. 12, FIG. 12 is an architectural diagram of another storage system according to an embodiment of the present disclosure. The storage system includes a processing unit 1201, a storage unit 1202 connected to the processing unit 1201, and a systolic array 1203 connected to the processing unit 1201. The systolic array 1203 comprises a plurality of weight registers configured to register weight data.

The storage unit 1202 is configured to store the weight data and feature-map data.

The processing unit 1201 is configured to acquire a first weight read request and a first feature-map read request, where the first weight read request is configured to request reading the weight data from the storage unit, and the first feature-map read request is configured to request reading feature-map data from the storage unit.

The processing unit 1201 is further configured to acquire a reference status identifier, where the reference status identifier indicates a predicted status of the weight registers in the systolic array at a first moment, the first moment is post to a current moment by a pre-defined elapsed time interval.

The processing unit 1201 is further configured to read the weight data from the storage unit and store the read weight data into the systolic array 1203, in response to the first weight read request and the reference status identifier satisfying a first pre-defined condition.

The processing unit 1201 is further configured to read the feature-map data from the storage unit and input the read feature map into the systolic array 1203, in response to the first feature-map read request and the reference status identifier satisfying a second pre-defined condition.

The systolic array 1203 is configured to perform calculation using the weight data and the feature-map data that are stored in the systolic array.

In all embodiments of the present disclosure, the processing unit 1201 may comprise a first status register, a reference status register, and a determining unit.

The first status register is configured to register a first status identifier, and the first status identifier indicates whether the plurality of weight register finishes registering the weight data of a first clock cycle after the pre-defined elapsed time from the current time, where the first clock cycle is a clock cycle has a temporal sequential number of n among clock cycles in which the weight data are read, and n is a preset integer.

The reference status register is configured to register the reference status identifier.

The determining unit is configured to acquire the first status identifier; and determine the reference status identifier to indicate that the weight registers is not to register the weight data after the pre-defined elapsed time from the current time, in response to the first status identifier indicating that the plurality of weight register finishes registering the weight data of the first clock cycle after the pre-defined elapsed time from the current time. The second pre-defined condition is that the reference status identifier indicates that the weight registers are not to register the weight data after the pre-defined elapsed time from the current time.

In all embodiments of the present disclosure, the processing unit 1201 may comprise a second status register, a reference status register, and a determining unit.

The second status register is configured to register a second status identifier, and the second status identifier indicates whether calculation is performed on the weight data in the weight registers and the feature-map data, of a second clock cycle, after the pre-defined elapsed time from the current time, where the second clock cycle is an earliest clock cycle of reading the feature-map data from the storage unit after the reference status identifier indicates that the weight registers is not to register the weight data.

The reference status register is configured to register the reference status identifier.

The determining unit is configured to acquire the second status identifier; and determine the reference status identifier to indicate that the weight registers is to register the weight data after the pre-defined elapsed time from the current time, in response to the second status identifier indicating that the calculation is performed on the weight data in the weight registers and the feature-map data of the second clock cycle after the pre-defined elapsed time from the current time. The first pre-defined condition is that the reference status identifier indicates that the weight registers are to register the weight data after the pre-defined elapsed time from the current moment.

In all embodiments of the present disclosure, the processing unit 1201 may be further configured to acquire a second weight read request and a second feature-map read request, where the second weight read request is configured to request reading the weight data from the storage unit, and the second feature-map read request is configured to request reading the feature-map data from the storage unit.

The processing unit 1201 is further configured to read the weight data stored from the storage unit and store the read weight data into the systolic array 1203, in response to the second weight read request.

The processing unit 1201 is further configured to read the feature-map data from the storage unit and input the read feature-map data into the systolic array 1203, in response to the second feature-map read request. Both a read delay of the weight data and a read delay of the feature-map data are equal to the pre-defined elapsed time.

**In** all embodiments of the present disclosure, the processing unit 1201 may comprise a hash unit, a reading unit, and an acquisition unit, and the storage unit 1202 comprises at least one first storage block, and the storage unit comprises at least one first storage block.

Each first storage block is configured to store respective weight data or respective feature-map dat.

The hash unit is configured to determine a respective first storage block for each first weight sub-request, in a case that said first weight sub-request is determined to be a valid request.

The reading unit is configured to read the weight data for each first weight sub-request from the respective first storage block for said first weight sub-request.

The acquisition unit is configured to acquire the weight data for all first weight sub-requests and transmit the weight data for all first weight sub-requests to the systolic array 1203.

In all embodiments of the present disclosure, the system may further comprise a conflict detection unit.

The conflict detection unit is configured to extract, from each first weight sub-request, an address of the respective first storage block for said first weight sub-request.

The conflict detection unit is further configured to determine, for each first weigh sub-request, that said first weight sub-request is the valid request, in a case that the address of the respective first storage block for said first weight sub-request is different from an address of the respective first storage block for a reference first weight sub-request. The reference first weight sub-request comprises one or more first weight sub-requests other than said first weight sub-request.

In all embodiments of the present disclosure, each first storage block may comprise at least one second storage block.

Each second storage block is configured to store respective weight data and the respective feature-map data.

The reading unit is configured to determine a respective second storage block for each first weight sub-request; and read the weight data for each first weight sub-request from the respective second storage block for said first weight sub-request.

In all embodiments of the present disclosure, the processing unit 1201 may be further configured to acquire a write request, where the write request is configured to write the weight data or the feature-map data into the storage unit; and write the weight data or the feature-map data, which is indicated by the write request, into the storage unit.

In all embodiments of the present disclosure, the processing unit 1201 may comprise a hash unit and a writing unit, and the storage unit 1202 comprises at least one first storage block.

The hash unit is configured to determine, for each third sub-request, a respective first storage block for said third sub-request, and the write request comprises at least one third sub-request.

The writing unit is configured to write the weight data or the feature-map data indicated by each third sub-request into the respective first storage block for said third sub-request.

A function of the first status register, a function of the second status register, a function of the reference status register, and a function of the determining unit may be implemented through the arbiter unit as shown in FIG. 7. A function of the above-mentioned hash unit may be implemented through the hash unit as shown in FIG. 7. A function of the above-mentioned reading unit may be implemented through the scheduler and the selection unit as shown in FIG. 8. A function of the above-mentioned acquisition unit may be implemented through the acquisition unit as shown in FIG. 7. A function of the above-mentioned conflict detection unit may be implemented through the conflict detection unit as shown in FIG. 7. A function of the second storage block may be implemented through the second storage block as shown in FIG. 7. A function of the above-mentioned writing unit may be implemented through the scheduler as shown in FIG. 8.

The system provided in FIG. 12 above belongs to the same idea as the method embodiment. Details of a specific implementation process may refer to the method embodiment. In addition, the contents of the system provided in FIG. 12 corresponding to FIG. 7 and FIG. 8 may refer to the descriptions of FIG. 7 and FIG. 8, and details are not described herein again.

The above-mentioned system indicates the status of the weight register in the systolic array through the reference status identifier. The weight data stored in the storage unit is read and stored into the systolic array in response to the first weight read request, when the reference status identifier satisfies the first pre-defined condition. The feature-map data stored in the storage unit is read and stored into the systolic array in response to the first feature-map read request, when the reference status identifier satisfies the second pre-defined condition. The reference status identifier requires fewer registering resources than the queues. The system may be applied to a chip. The fewer the registering resources are utilized, the smaller the chip area is. Therefore, the apparatus in the chip facilitates reducing the chip area.

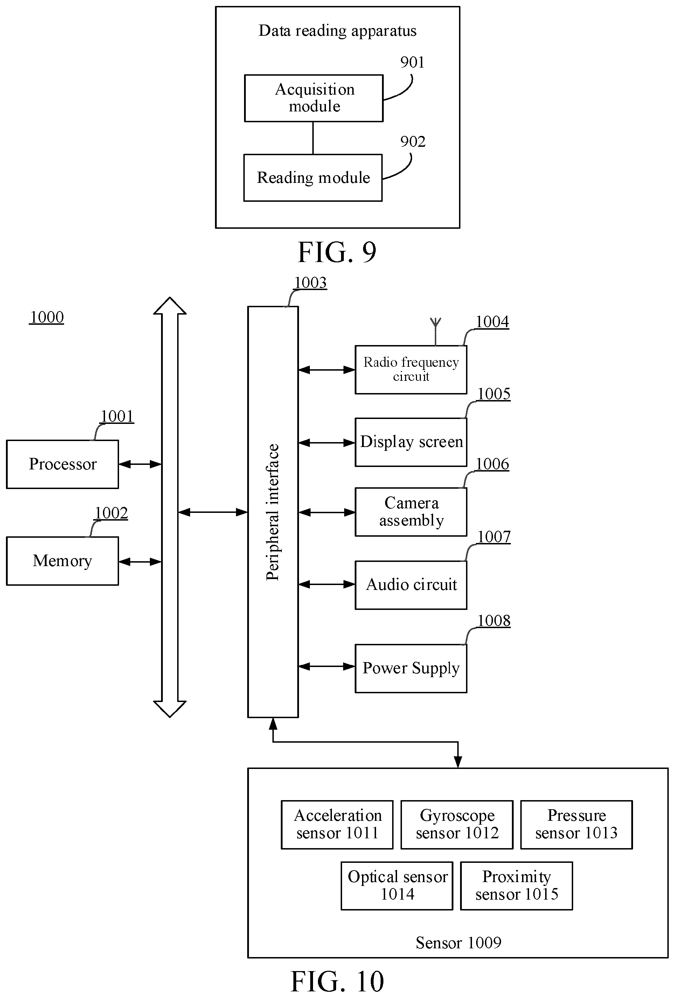

FIG. 9 is a schematic structural diagram of a data reading apparatus according to an embodiment of the present disclosure. As shown in FIG. 9, the apparatus comprises an acquisition module 901 and a reading module 902.

The acquisition module 901 is configured to acquire a first weight read request and a first feature-map read request, where the first weight read request is configured to request reading weight data from a storage unit, and the first feature-map read request is configured to request reading feature-map data from the storage unit.

The acquisition module 901 is further configured to acquire a reference status identifier, where the reference status identifier indicates a predicted status of the weight registers in the systolic array at a first moment, the first moment is post to a current moment by a pre-defined elapsed time interval, and the weight registers are configured to register the weight data.

The reading module 902 is configured to read the weight data from the storage unit and store the read weight data into the systolic array, in response to the first weight read request and the reference status identifier satisfying a first pre-defined condition.

The reading module 902 is further configured to read the feature-map data from the storage unit and input the read feature map into the systolic array, in response to the first feature-map read request and the reference status identifier satisfying a second pre-defined condition, where the systolic array is configured to perform calculation using the weight data and the feature-map data that are stored in the systolic array.

In all embodiments of the present disclosure, the first pre-defined condition may be that the reference status identifier indicates that the weight registers is to register the weight data after the pre-defined elapsed time from the current moment.

In all embodiments of the present disclosure, the second pre-defined condition may be that the reference status identifier indicates that the weight registers are not to register the weight data after the pre-defined elapsed time from the current time.

In all embodiments of the present disclosure, the acquisition module 901 may be further configured to acquire a first status identifier, where the first status identifier indicates whether the plurality of weight register finishes registering the weight data of a first clock cycle after the pre-defined elapsed time from the current time, and the first clock cycle is a clock cycle has a temporal sequential number of n among clock cycles in which the weight data are read, and n is a preset integer.

The apparatus further comprise a determining module configured to determine the reference status identifier to indicate that the weight registers is not to register the weight data after the pre-defined elapsed time from the current time, in response to the first status identifier indicating that the plurality of weight register finishes registering the weight data of the first clock cycle after the pre-defined elapsed time from the current time.

In all embodiments of the present disclosure, the acquisition module 901 may be further configured to acquire a second status identifier, where the second status identifier indicates whether calculation is performed on the weight data in the weight registers and the feature-map data, of a second clock cycle, after the pre-defined elapsed time from the current time, and the second clock cycle is an earliest clock cycle of reading the feature-map data from the storage unit after the reference status identifier indicates that the weight registers is not to register the weight data .

The apparatus further comprises a determining module configured to determine the reference status identifier to indicate that the weight registers is to register the weight data after the pre-defined elapsed time from the current time, in response to the second status identifier indicating that the calculation is performed on the weight data in the weight registers and the feature-map data of the second clock cycle after the pre-defined elapsed time from the current time.

In all embodiments of the present disclosure, the acquisition module 901 may be further configured to acquire a second weight read request and a second feature-map read request, where the second weight read request is configured to request reading the weight data from the storage unit, and the second feature-map read request is configured to request reading the feature-map data from the storage unit.

The reading module 902 is further configured to: read the weight data stored from the storage unit and storing the read weight data into the systolic array, in response to the second weight read request; and read the feature-map data from the storage unit and inputting the read feature-map data into the systolic array, in response to the second feature-map read request, where both a read delay of the weight data and a read delay of the feature-map data are equal to the pre-defined elapsed time.

In all embodiments of the present disclosure, the first weight read request may comprise at least one first weight sub-request, and the storage unit comprises at least one first storage block.

The reading module 902 is configured to, for each weight sub-request: determine a respective first storage block for said first weight sub-request, in a case that said first weight sub-request is determined to be a valid request; read the weight data for said first weight sub-request from the respective first storage block; and transmit the weight data for said first weight sub-request to the systolic array.

In all embodiments of the present disclosure, the apparatus may further comprise an extraction module and a determining module.

The extraction module is configured to extract, from each first weight sub-request, an address of the respective first storage block for said first weight sub-request.

The determining module is configured to determining, for each first weight sub-request, that said first weight sub-request is the valid request, in a case that the address of the respective first storage block for said first weight sub-request is different from an address of the respective first storage block for a reference first weight sub-request, where the reference first weight sub-request comprises one or more first weight sub-requests other than said first weight sub-request.

In all embodiments of the present disclosure, each first storage block may comprise at least one second storage block.

The read module 902 is configured to determine a respective second storage block for said first weight sub-request; and read the weight data for said first weight sub-request from the respective second storage block.

In all embodiments of the present disclosure, the acquisition module 901 may be further configured to acquire a write request, where the write request is configured to write the weight data or the feature-map data into the storage unit.

The apparatus further includes a writing module.

The writing module is configured to write the weight data or the feature-map data, which is indicated by the write request, into the storage unit.

In all embodiments of the present disclosure, the write request may comprise at least one third sub-request, and the storage unit comprises at least one first storage block.

The writing module is configured to, for each third sub-request: determine a respective first storage block for said third sub-request; and write the weight data or the feature-map data indicated by said third sub-request into the respective first storage block.

The above-mentioned apparatus indicates the status of the weight register in the systolic array through the reference status identifier. The weight data stored in the storage unit is read and stored into the systolic array in response to the first weight read request, when the reference status identifier satisfies the first pre-defined condition. The feature-map data stored in the storage unit is read and stored into the systolic array in response to the first feature-map read request, when the reference status identifier satisfies the second pre-defined condition. The reference status identifier requires fewer registering resources than the queue. The apparatus may be applied to a chip. The fewer the registering resources are utilized, the smaller the chip area is. Therefore, the apparatus in the chip facilitates reducing the chip area.

When the apparatus provided in FIG. 9 implements the functions of the apparatus, division of the foregoing function modules is only used as an example for description. In the practical application, the above-mentioned functions may be allocated to and completed by different function modules according to requirements. That is, an internal structure of the device is divided into different function modules to complete all or some of the functions described above. In addition, the apparatus provided in the foregoing embodiment belongs to the same idea as the method embodiment. Details of a specific implementation process may refer to the method embodiment, and details are not described herein again.

FIG. 10 is a structural block diagram of a terminal device 1000 according to an exemplary embodiment of the present disclosure. The terminal device 1000 includes: a processor 1001 and a memory 1002.

The processor 1001 may include one or more processing cores, for example, a 4-core processor or an 8-core processor. The processor 1001 may be implemented in at least one hardware form of digital signal processing (DSP), a field-programmable gate array (FPGA), and a programmable logic array (PLA). The processor 1001 may also include a main processor and a coprocessor. The main processor is a processor configured to process data in an awake status and is also referred to as a central processing unit (CPU). The coprocessor is a low-power-consumption processor configured to process data in a standby status. In some embodiments, the processor 1001 may be integrated with a graphics processing unit (GPU). The GPU is configured to render and draw content that needs to be displayed on a display screen. In some embodiments, the processor 1001 may further include an AI processor. The AI processor is configured to process computing operations related to machine learning.

The memory 1002 may include one or more computer-readable storage media. The computer-readable storage medium may be non-transient. The memory 1002 may further include a high-speed random access memory and a nonvolatile memory, for example, one or more disk storage devices or flash storage devices. In some embodiments, the non-transient computer-readable storage medium in the memory 1002 is configured to store at least one computer-readable instruction. The at least one computer-readable instruction is configured to be executed by the processor 1001 to implement the data reading method provided in the method embodiments of the present disclosure.

In some embodiments, the terminal device 1000 may further include: a peripheral device interface 1003 and at least one peripheral device. The processor 1001, the memory 1002, and the peripheral device interface 1003 may be connected through a bus or a signal line. Each peripheral device may be connected to the peripheral device interface 1003 through a bus, a signal line, or a circuit board. Specifically, the peripheral device includes: at least one of a radio frequency (RF) circuit 1004, a display screen 1005, a camera assembly 1006, an audio circuit 1007, or a power supply 1008.

The peripheral device interface 1003 may be configured to connect at least one peripheral device related to input/output (I/O) to the processor 1001 and the memory 1002. In some embodiments, the processor 1001, the memory 1002, and the peripheral device interface 1003 are integrated on the same chip or circuit board. In some other embodiments, any one or two of the processor 1001, the memory 1002, and the peripheral device interface 1003 may be implemented on a single chip or circuit board. This is not limited in this embodiment.

The RF circuit 1004 is configured to receive and transmit an RF signal, also referred to as an electromagnetic signal. The RF circuit 1004 communicates with a communication network and other communication devices through the electromagnetic signal. The RF circuit 1004 converts an electrical signal into an electromagnetic signal for transmission, or converts a received electromagnetic signal into an electrical signal. In one embodiment, the RF circuit 1004 includes: an antenna system, an RF transceiver, one or more amplifiers, a tuner, an oscillator, a digital signal processor, a codec chipset, a user identity module card, and the like. The RF circuit 1004 may communicate with another terminal through at least one wireless communication protocol. The wireless communication protocol includes but is not limited to a world wide web, a metropolitan area network, an intranet, various generations of mobile communication networks (2G, 3G, 4G, and 5G), a wireless local area network, and/or a wireless fidelity (WiFi) network. In some embodiments, the RF 1004 may further include a circuit related to near field communication (NFC). This is not limited in the present disclosure.

The display screen 1005 is configured to display a user interface (UI). The UI may include a graph, text, an icon, a video, and any combination thereof. When the display screen 1005 is a touch display screen, the display screen 1005 further has a capability of acquiring a touch signal on or above a surface of the display screen 1005. The touch signal may be inputted to the processor 1001 as a control signal for processing. In this case, the display screen 1005 may be further configured to provide a virtual button and/or a virtual keyboard, referred to as a soft button and/or a soft keyboard. In some embodiments, one display screen 1005 may be provided on a front panel of the terminal device 1000. In some other embodiments, there may be at least two display screens 1005 provided on different surfaces of the terminal device 1000 or in a folded design. In some other embodiments, the display screen 1005 may be a flexible display screen provided on a curved surface or a folded surface of the terminal device 1000. Even, the display screen 1005 may be further provided in a non-rectangular irregular pattern, i.e., a special-shaped screen. The display screen 1005 may be prepared using materials such as a liquid crystal display (LCD) and an organic light-emitting diode (OLED).

The camera assembly 1006 is configured to acquire images or videos. In one embodiment, the camera assembly 1006 includes a front camera and a rear camera. Generally, the front camera is provided on the front panel of the terminal, and the rear camera is provided on a back surface of the terminal. In some embodiments, there are at least two rear cameras, which are any of main cameras, depth-of-field cameras, wide-angle cameras, and telephoto cameras, to achieve a background blur function through fusion of the main camera and the depth-of-field camera, panoramic photographing and virtual reality (VR) photographing functions through fusion of the main camera and the wide-angle camera, or other fusion photographing functions. In some embodiments, the camera assembly 1006 may further include a flash. The flash may be a monochrome temperature flash, or may be a double color temperature flash. The double color temperature flash refers to a combination of a warm light flash and a cold light flash, and may be configured for light compensation under different color temperatures.

The audio circuit 1007 may include a microphone and a speaker. The microphone is configured to acquire sound waves of a user and an environment, and convert the sound waves into electrical signals to input to the processor 1001 for processing, or input to the RF circuit 1004 for implementing voice communication. For the purpose of stereo acquisition or noise reduction, there may be a plurality of microphones, provided at different portions of the terminal device 1000. The microphone may further be an array microphone or an omni-directional acquisition type microphone. The speaker is configured to convert the electrical signals from the processor 1001 or the RF circuit 1004 into sound waves. The speaker may be a conventional film speaker, or may be a piezoelectric ceramic speaker. When the speaker is the piezoelectric ceramic speaker, the speaker may not only convert the electrical signal into a sound wave audible to the human being, but also convert the electrical signal into a sound wave inaudible to the human being, for ranging and other purposes. In some embodiments, the audio circuit 1007 may further include an earphone jack.

The power supply 1008 is configured to supply power to assemblies in the terminal device 1000. The power supply 1008 may be an alternating current, a direct current, a disposable battery, or a rechargeable battery. When the power supply 1008 includes a rechargeable battery, the rechargeable battery may be a wired rechargeable battery or a wireless rechargeable battery. The wired rechargeable battery is a battery charged through a wired line, and the wireless rechargeable battery is a battery charged through a wireless coil. The rechargeable battery may be further configured to support a fast charging technology.

In some embodiments, the terminal device 1000 further includes one or more sensors 1009. The one or more sensors 1009 include, but are not limited to, an acceleration sensor 1011, a gyroscope sensor 1012, a pressure sensor 1013, an optical sensor 1014, and a proximity sensor 1015.

The acceleration sensor 1011 may detect magnitudes of accelerations on three coordinate axes of a coordinate system established with the terminal device 1000. For example, the acceleration sensor 1011 may be configured to detect components of gravity acceleration on the three coordinate axes. The processor 1001 may control the display screen 1005 to display the UI in a landscape view or a portrait view according to a gravity acceleration signal acquired by the acceleration sensor 1011. The acceleration sensor 1011 may be further configured to acquire motion data of a game or a user.

The gyroscope sensor 1012 may detect a body direction and a rotation angle of the terminal device 1000. The gyroscope sensor 1012 may cooperate with the acceleration sensor 1011 to acquire a 3D action by the user on the terminal device 1000. The processor 1001 may realize the following functions according to the data acquired by the gyroscope sensor 1012: action sensing (such as changing the UI according to a tilt operation of the user), image stabilization during photographing, game control, and inertial navigation.

The pressure sensor 1013 may be provided at a side frame of the terminal device 1000 and/or a lower layer of the display screen 1005. When the pressure sensor 1013 is provided at the side frame of the terminal device 1000, a holding signal of the user on the terminal device 1000 may be detected. The processor 1001 performs left and right hand recognition or a quick operation according to the holding signal acquired by the pressure sensor 1013. When the pressure sensor 1013 is provided on the low layer of the display screen 1005, the processor 1001 controls an operable control on the UI according to a pressure operation of the user on the display screen 1005. The operable control includes at least one of a button control, a scroll-bar control, an icon control, and a menu control.

The optical sensor 1014 is configured to acquire ambient light intensity. In one embodiment, the processor 1001 may control the display brightness of the display screen 1005 according to the ambient light intensity acquired by the optical sensor 1014. Specifically, when the ambient light intensity is high, the display brightness of the display screen 1005 is increased. When the ambient light intensity is low, the display brightness of the display screen 1005 is decreased. In another embodiment, the processor 1001 may further dynamically adjust photographing parameters of the camera assembly 1006 according to the ambient light intensity acquired by the optical sensor 1014.

The proximity sensor 1015, also referred to as a distance sensor, is generally provided on the front panel of the terminal device 1000. The proximity sensor 1015 is configured to acquire a distance between the user and a front surface of the terminal device 1000. In one embodiment, when the proximity sensor 1015 detects that the distance between the user and the front surface of the terminal device 1000 gradually decreases, the display screen 1005 is controlled by the processor 1001 to switch from a screen-on status to a screen-off status. When the proximity sensor 1015 detects that the distance between the user and the front surface of the terminal device 1000 gradually increases, the display screen 1005 is controlled by the processor 1001 to switch from the screen-off status to the screen-on status.

A person skilled in the art may understand that the structure shown in FIG. 10 constitutes no limitation on the terminal device 1000, and the terminal device may include more or fewer assemblies than those shown in the figure, or a combination of some assemblies, or have a different arrangement of assemblies.

FIG. 11 is a schematic structural diagram of a server according to an embodiment of the present disclosure. The server 1100 may vary greatly due to different configurations or performances and may include one or more processors 1101 and one or more memories 1102. The one or more memories 1102 have at least one computer-readable instruction stored therein. The at least one computer-readable instruction is loaded and executed by the one or more processors 1101 to implement the data reading method provided in the foregoing method embodiments. As an example, the processor 1101 is a CPU. The server 1100 may further have components such as a wired or wireless network interface, a keyboard, and an I/O interface for inputting and outputting. The server 1100 may further include other components configured to implement device functions, and details are not described herein.

According to an exemplary embodiment, a computer-readable storage medium is further provided, having at least one computer-readable instruction stored therein. The at least one computer-readable instruction is loaded and executed by a processor to cause an electronic device to implement the data reading method according to any one of the foregoing aspects.

In one embodiment, the above-mentioned computer-readable storage medium may be a read-only memory (ROM), a random access memory (RAM), a compact disc read-only memory (CD-ROM), a magnetic tape, a floppy disk, an optical data storage device, or the like.

According to an exemplary embodiment, a computer program product is further provided, having at least one computer-readable instruction stored therein. The at least one computer-readable instruction is loaded and executed by a processor to cause an electronic device to implement the data reading method according to any one of the foregoing aspects.

"A plurality of" mentioned herein refers to two or more. "And/or" describes an association relationship of associated objects and represents that three relationships may exist. For example, A and/or B may represent the following three cases: only A exists, both A and B exist, and only B exists. The character "/" generally indicates an "or" relationship between the associated objects.

The foregoing descriptions are merely exemplary embodiments of the present disclosure, but are not intended to limit the present disclosure. Any modification, equivalent replacement, or improvement made within the principle of the present disclosure shall fall within the protection scope of the present disclosure.

Technical features of the foregoing embodiments may be combined in different manners to form other embodiments. To make description concise, not all possible combinations of the technical features in the foregoing embodiments are described. However, the combinations of these technical features shall be considered as falling within the scope recorded by this specification provided that no conflict exists.

The foregoing embodiments only describe several implementations of the present disclosure, which are described specifically and in detail, but cannot be construed as a limitation to the patent scope of the present disclosure. For a person skilled in the art, several transformations and improvements may be made without departing from the idea of the present disclosure. These transformations and improvements belong to the protection scope of the present disclosure. Therefore, the protection scope of the patent of the present disclosure shall be subject to the appended claims.

## Claims

1. A data reading method, executable by a processor of an electronic device comprising a systolic array and a storage unit that are connected to the processor, the systolic array comprising a plurality of weight registers configured to register weight data, wherein the method comprises:
acquiring a first weight read request and a first feature-map read request, wherein the first weight read request is configured to request reading the weight data from the storage unit, and the first feature-map read request is configured to request reading feature-map data from the storage unit;
acquiring a reference status identifier, wherein the reference status identifier indicates a predicted status of the weight registers in the systolic array at a first moment, and the first moment is post to a current moment by a pre-defined elapsed time interval;
reading the weight data from the storage unit and storing the read weight data into the systolic array, in response to the first weight read request and the reference status identifier satisfying a first pre-defined condition; and
reading the feature-map data from the storage unit and inputting the read feature map into the systolic array, in response to the first feature-map read request and the reference status identifier satisfying a second pre-defined condition, wherein the systolic array is configured to perform calculation using the weight data and the feature-map data that are stored in the systolic array.

2. The method according to claim 1, wherein the first pre-defined condition is that the reference status identifier indicates that the weight registers is to register the weight data after the pre-defined elapsed time from the current moment.

3. The method according to claim 1 or 2, wherein the second pre-defined condition is that the reference status identifier indicates that the weight registers is not to register the weight data after the pre-defined elapsed time from the current time.

4. The method according to claim 2, further comprising:
acquiring a first status identifier, wherein the first status identifier indicates whether the plurality of weight register finishes registering the weight data of a first clock cycle after the pre-defined elapsed time from the current time, and the first clock cycle is a clock cycle has a temporal sequential number of n among clock cycles in which the weight data are read, and n is a preset integer; and
determining the reference status identifier to indicate that the weight registers is not to register the weight data after the pre-defined elapsed time from the current time, in response to the first status identifier indicating that the plurality of weight register finishes registering the weight data of the first clock cycle after the pre-defined elapsed time from the current time.

5. The method according to claim 3, further comprising:
acquiring a second status identifier, wherein the second status identifier indicates whether calculation is performed on the weight data in the weight registers and the feature-map data, of a second clock cycle, after the pre-defined elapsed time from the current time, and the second clock cycle is an earliest clock cycle of reading the feature-map data from the storage unit after the reference status identifier indicates that the weight registers is not to register the weight data; and
determining the reference status identifier to indicate that the weight registers is to register the weight data after the pre-defined elapsed time from the current time, in response to the second status identifier indicating that the calculation is performed on the weight data in the weight registers and the feature-map data of the second clock cycle after the pre-defined elapsed time from the current time.

6. The method according to any one of claims 1 to 5, wherein after reading the feature-map data from the storage unit and inputting the read feature map into the systolic array, the method further comprises:
acquiring a second weight read request and a second feature-map read request, wherein the second weight read request is configured to request reading the weight data from the storage unit, and the second feature-map read request is configured to request reading the feature-map data from the storage unit;
reading the weight data stored from the storage unit and storing the read weight data into the systolic array, in response to the second weight read request; and
reading the feature-map data from the storage unit and inputting the read feature-map data into the systolic array, in response to the second feature-map read request,
wherein both a read delay of the weight data and a read delay of the feature-map data are equal to the pre-defined elapsed time.

7. The method according to any one of claims 1 to 6, wherein:
the first weight read request comprises at least one first weight sub-request, and the storage unit comprises at least one first storage block; and
reading the weight data from the storage unit and storing the read weight data into the systolic array comprises, for each first weight sub-request:
in a case that said first weight sub-request is determined to be a valid request,
determining a respective first storage block for said first weight sub-request, and
reading the weight data for said first weight sub-request from the respective first storage block; and
transmitting the weight data for said first weight sub-request to the systolic array.

8. The method according to claim 7, further comprising, for each weight sub-request:
extracting, from said first weight sub-request, an address of the respective first storage block for said first weight sub-request; and
determining that said first weight sub-request is the valid request, in a case that the address of the respective first storage block for said first weight sub-request is different from an address of the respective first storage block for a reference first weight sub-request, wherein the reference first weight sub-request comprises one or more first weight sub-requests other than said first weight sub-request.

9. The method according to claim 7, wherein:
each first storage block comprises at least one second storage block; and
reading the weight data for said first weight sub-request from the respective first storage block comprises:
determining a respective second storage block for said first weight sub-request; and
reading the weight data for said first weight sub-request from the respective second storage block.

10. The method according to any one of claims 1 to 9, further comprising:
acquiring a write request, wherein the write request is configured to write the weight data or the feature-map data into the storage unit; and
writing the weight data or the feature-map data, which is indicated by the write request, into the storage unit.

11. The method according to claim 10, wherein:
the write request comprises at least one third sub-request, and the storage unit comprises at least one first storage block; and
writing the weight data or the feature-map data, which is indicated by the write request, into the storage unit comprises, for each third sub-request:
determining a respective first storage block for said third sub-request; and
writing the weight data or the feature-map data indicated by said third sub-request into the respective first storage block.

12. A storage system, comprising a processing unit, a storage unit connected to the processing unit, and a systolic array connected to the processing unit, the systolic array comprising a plurality of weight registers configured to register weight data, wherein:
the storage unit is configured to store the weight data and feature-map data;
the processing unit is configured to acquire a first weight read request and a first feature-map read request, wherein the first weight read request is configured to request reading the weight data from the storage unit, and the first feature-map read request is configured to request reading feature-map data from the storage unit;
the processing unit is further configured to acquire a reference status identifier, wherein the reference status identifier indicates a predicted status of the weight registers in the systolic array at a first moment, the first moment is post to a current moment by a pre-defined elapsed time interval;
the processing unit is further configured to read the weight data from the storage unit and store the read weight data into the systolic array, in response to the first weight read request and the reference status identifier satisfying a first pre-defined condition; and
the processing unit is further configured to reading the feature-map data from the storage unit and input the read feature map into the systolic array, in response to the first feature-map read request and the reference status identifier satisfying a second pre-defined condition; and
the systolic array is configured to perform calculation using the weight data and the feature-map data that are stored in the systolic array.

13. The system according to claim 12, wherein:
the processing unit comprises a first status register, a reference status register, and a determining unit;
the first status register is configured to register a first status identifier, and the first status identifier indicates whether the plurality of weight register finishes registering the weight data of a first clock cycle after the pre-defined elapsed time from the current time, wherein the first clock cycle is a clock cycle has a temporal sequential number of n among clock cycles in which the weight data are read, and n is a preset integer;
the reference status register is configured to register the reference status identifier;
the determining unit is configured to:
acquire the first status identifier; and
determine the reference status identifier to indicate that the weight registers is not to register the weight data after the pre-defined elapsed time from the current time, in response to the first status identifier indicating that the plurality of weight register finishes registering the weight data of the first clock cycle after the pre-defined elapsed time from the current time; and
the second pre-defined condition is that the reference status identifier indicates that the weight registers is not to register the weight data after the pre-defined elapsed time from the current time.

14. The system according to claim 12 or 13, wherein:
the processing unit comprises a second status register, a reference status register, and a determining unit;
the second status register is configured to register a second status identifier, and the second status identifier indicates whether calculation is performed on the weight data in the weight registers and the feature-map data, of a second clock cycle, after the pre-defined elapsed time from the current time, wherein the second clock cycle is an earliest clock cycle of reading the feature-map data from the storage unit after the reference status identifier indicates that the weight registers is not to register the weight data;
the reference status register is configured to register the reference status identifier; and
the determining unit is configured to:
acquire the second status identifier; and
determine the reference status identifier to indicate that the weight registers is to register the weight data after the pre-defined elapsed time from the current time, in response to the second status identifier indicating that the calculation is performed on the weight data in the weight registers and the feature-map data of the second clock cycle after the pre-defined elapsed time from the current time; and
the first pre-defined condition is that the reference status identifier indicates that the weight registers is to register the weight data after the pre-defined elapsed time from the current moment.

15. The system according to any one of claims 12 to 14, wherein:
the processing unit is further configured to acquire a second weight read request and a second feature-map read request, wherein the second weight read request is configured to request reading the weight data from the storage unit, and the second feature-map read request is configured to request reading the feature-map data from the storage unit;
the processing unit is further configured to read the weight data stored from the storage unit and store the read weight data into the systolic array, in response to the second weight read request; and
the processing unit is further configured to read the feature-map data from the storage unit and input the read feature-map data into the systolic array, in response to the second feature-map read request;
wherein both a read delay of the weight data and a read delay of the feature-map data are equal to the pre-defined elapsed time.

16. The system according to any one of claims 12 to 15, wherein:
the processing unit comprises a hash unit, a reading unit, and an acquisition unit, the first weight read request comprises at least one first weight sub-request, and the storage unit comprises at least one first storage block;
each first storage block is configured to store respective weight data or respective feature-map data;
the hash unit is configured to determine a respective first storage block for each first weight sub-request, in a case that said first weight sub-request is determined to be a valid request;
the reading unit is configured to read the weight data for each first weight sub-request from the respective first storage block for said first weight sub-request; and
the acquisition unit is configured to acquire the weight data for all first weight sub-requests and transmit the weight data for all first weight sub-requests to the systolic array.

17. The system according to claim 16, further comprising a conflict detection unit, configured to, for each first weight sub-request:
extract, from said first weight sub-request, an address of the respective first storage block for said first weight sub-request; and
determine that said first weight sub-request is the valid request, in a case that the address of the respective first storage block for said first weight sub-request is different from an address of the respective first storage block for a reference first weight sub-request, wherein the reference first weight sub-request comprises one or more first weight sub-requests other than said first weight sub-request.

18. The system according to claim 16, wherein:
each first storage block comprises at least one second storage block, and each second storage block is configured to store respective weight data and the respective feature-map data; and
the reading unit is configured to:
determine a respective second storage block for each first weight sub-request; and
read the weight data for each first weight sub-request from the respective second storage block for said first weight sub-request.

19. The system according to any one of claims 12 to 18, wherein the processing unit is further configured to:
acquire a write request, wherein the write request is configured to write the weight data or the feature-map data into the storage unit; and
write the weight data or the feature-map data, which is indicated by the write request, into the storage unit.

20. The system according to claim 19, wherein the processing unit comprises a hash unit and a writing unit, the write request comprises at least one third sub-request, and the storage unit comprises at least one first storage block;
the hash unit is configured to determine, for each third sub-request, a respective first storage block for said third sub-request, and the write request comprises at least one third sub-request; and
the writing unit is configured to write the weight data or the feature-map data indicated by each third sub-request into the respective first storage block for said third sub-request.

21. A data reading apparatus, comprising an acquisition module and a reading module, wherein:
the acquisition module is configured to acquire a first weight read request and a first feature-map read request, wherein the first weight read request is configured to request reading weight data from a storage unit, and the first feature-map read request is configured to request reading feature-map data from the storage unit;
the acquisition module is further configured to acquire a reference status identifier, wherein the reference status identifier indicates a predicted status of the weight registers in the systolic array at a first moment, the first moment is post to a current moment by a pre-defined elapsed time interval, and the weight registers are configured to register the weight data;
the reading module is configured to read the weight data from the storage unit and store the read weight data into the systolic array, in response to the first weight read request and the reference status identifier satisfying a first pre-defined condition; and
the reading module is further configured to read the feature-map data from the storage unit and input the read feature map into the systolic array, in response to the first feature-map read request and the reference status identifier satisfying a second pre-defined condition, wherein the systolic array is configured to perform calculation using the weight data and the feature-map data that are stored in the systolic array.

22. An electronic device, comprising a processor and a memory, the memory having at least one computer-readable instruction stored therein, and the at least one computer-readable instruction being loaded and executed by the processor to cause the electronic device to implement the data reading method according to any one of claims 1 to 11.

23. A computer-readable storage medium, having at least one computer-readable instruction stored therein, the at least one computer-readable instruction being loaded and executed by a processor to cause an electronic device to implement the data reading method according to any one of claims 1 to 11.
